# EUROPEAN PATENT SPECIFICATION

(11) **EP 1 987 507 B1**
(45) Date of publication and mention of the grant of the patent: **04.06.2014**
(21) Application number: 07710608.6
(22) Date of filing: 09.02.2007
(51) Int. Cl.: G09G 3/20, G09G 3/32

(54) **METHOD AND SYSTEM FOR ELECTROLUMINESCENT DISPLAYS**
VERFAHREN UND SYSTEM FÜR ELEKTROLUMINESZENZANZEIGEVORRICHTUNGEN
PROCEDE ET SYSTEME POUR AFFICHEURS ELECTROLUMINESCENTS

(30) Priority: 10.02.2006 CA 2536398; 18.05.2006 CA 2547671; 27.11.2006 CA 2569156
(43) Date of publication of application: 05.11.2008
(73) Proprietor: Ignis Innovation Inc., Waterloo, Ontario N2V 2C5 (CA)
(72) Inventor: NATHAN, Arokia, Cambridge CB3 0DL (GB); CHAJI, Reza G., Waterloo, Ontario N2V 2S3 (CA)
(74) Representative: Grünecker, Kinkeldey, Stockmair & Schwanhäusser
(86) International application number: PCT/CA2007/000192
(87) International publication number: WO 2007/090287

(56) References cited:
- EP-A1- 1 381 019
- WO-A1-2006/063448
- CA-A1- 2 472 671
- CA-A1- 2 522 396
- CA-A1- 2 567 076
- US-A1- 2002 186 214
- US-A1- 2005 110 420
- US-B1- 6 771 028
- US-B2- 6 995 519
- US-B2- 7 106 285

## Description

### FIELD OF INVENTION

The present invention relates to display technologies, more specifically to a method and system for light emitting device displays

### BACKGROUND OF THE INVENTION

Electro-luminance displays have been developed for a wide variety of devices, such as cell phones. In particular, active-matrix organic light emitting diode (AMOLED) displays with amorphous silicon (a-Si), poly-silicon, organic, or other driving backplane have become more attractive due to advantages, such as feasible flexible displays, its low cost fabrication, high resolution, and a wide viewing angle.

An AMOLED display includes an array of rows and columns of pixels, each having an organic light emitting diode (OLED) and backplane electronics arranged in the array of rows and columns. Since the OLED is a current driven device, the pixel circuit of the AMOLED should be capable of providing an accurate and constant drive current.

WO 2006/063448 (A1) describes a method and system for programming, calibrating and driving a light emitting device display is provided, which includes extracting a time dependent parameter of a pixel for calibration.

EP 1381019 (A1) describes an active type display panel that comprises a plurality of pixel sections, each having a series circuit constituted by a light emitting element and a drive element for supplying a drive current to the light emitting element, a pair of power supply lines which connect the series circuits of the pixel sections in parallel, and a plurality of measurement lines. Each of the pixel sections includes a switch element between a point connecting the light emitting element and the drive element, and one line of the measurement lines. A display device, in which the display panel is used, detects the voltage across the terminals of the light emitting element and controls the drive element such that the voltage across these terminals is a predetermined voltage.

US 2005110420 (A1) describes an organic light emitting diode display that includes an array of OLEDs, a voltage sensing circuit for each OLED including a transistor in each circuit connected to one of the terminals of a corresponding OLED for sensing the voltage across the OLED to produce feedback signals representing the voltage across the OLEDs, and a controller responsive to the feedback signals for calculating a correction signal for each OLED and applying the correction signal to data used to drive each OLED to compensate for the changes in the output of each OLED.

There is a need to provide a method and system that is capable of providing constant brightness with high accuracy.

### SUMMARY OF THE INVENTION

It is an object of the invention to provide a method and system that obviates or mitigates at least one of the disadvantages of existing systems.

This object is achieved by the present invention as claimed in the independent claims. Advantageous and preferred embodiments of the present invention are defined by the dependent claims.

According to an aspect there is provided a display system including one or more pixels. Each pixel includes a light emitting device, a drive transistor for driving the light emitting device, and a switch transistor for selecting the pixel. The display system includes a circuit for monitoring and extracting the change of the pixel to calibrate programming data for the pixel.

According to another aspect there is provided a method of driving the display system. The display system includes one or more than pixels. The method includes the steps of at an extraction cycle, providing an operation signal to the pixel, monitoring a node in the pixel, extracting the aging of the pixel based on the monitoring result ; and at a programming cycle, calibrating programming data based on the extraction of the aging of the pixel and providing the programming data to the pixel.

### BRIEF DESCRIPTION OF THE DRAWINGS

These and other features of the invention will become more apparent from the following description in which reference is made to the appended drawings wherein:
Figure 1 illustrates an example of a pixel array having a 2-transistor (2T) pixel circuit to which a pixel operation technique is suitably applied;
Figure 2 illustrates another example of a pixel array having a 2T pixel circuit to which the pixel operation technique associated with Figure 1 is suitably applied;
Figure 3A illustrates an example of signal waveforms applied to the pixel circuits of Figures 1 and 2 during an extraction operation;
Figure 3B illustrates an example of signal waveforms applied to the pixel circuits of Figures 1 and 2 during a normal operation;
Figure 4 illustrates the effect of shift in the threshold voltage of a drive transistor on the voltage of VDD during the extraction cycles of Figure 3A;
Figure 5 illustrates an example of a display system having the pixel array of Figure 1 or 2;
Figure 6 illustrates an example of normal and extraction cycles for driving the pixel array of Figure 5;
Figure 7 illustrates an example of a 3-transistor (3T) pixel circuit to which a pixel operation technique in accordance with an embodiment of the present invention is suitably applied;
Figure 8 illustrates another example of a 3T pixel circuit to which the pixel operation technique associated with Figure 7 is suitably applied;
Figure 9A illustrates an example of signal waveforms applied to the pixel circuits of Figures 7 and 8 during an extraction operation;
Figure 9B illustrates an example of signal waveforms applied to the pixel circuits of Figures 7 and 8 during a normal operation;
Figure 10 illustrates an example of a display system having the pixel circuit of Figure 7 or 8;
Figure 11A illustrates an example of normal and extraction cycles for driving the pixel array of Figure 10;
Figure 11B illustrates another example of normal and extraction cycles for driving the pixel array of Figure 10;
Figure 12 illustrates another example of a display system having the pixel circuit of Figure 7 or 8;
Figure 13 illustrates an example of normal and extraction cycles for driving the pixel array of Figure 12;
Figure 14 illustrates an example of a 4-transistor (4T) pixel circuit to which a pixel operation technique in accordance with a further embodiment of the present invention is suitably applied;
Figure 15 illustrates another example of a 4T pixel circuit to which the pixel operation technique associated with Figure 14 is suitably applied;
Figure 16A illustrates an example of signal waveforms applied to the pixel circuits of Figures 14 and 15 during an extraction operation;
Figure 16B illustrates an example of signal waveforms applied to the pixel circuits of Figures 14 and 15 during a normal operation;
Figure 17 illustrates an example of a display system having the pixel circuit of Figure 14 or 15;
Figure 18 illustrates an example of normal and extraction cycles for driving the pixel array of Figure 17;
Figure 19 illustrates another example of a display system having the pixel circuit of Figure 14 or 15;
Figure 20 illustrates an example of normal and extraction cycles for driving the pixel array of Figure 19;
Figure 21 illustrates an example of a 3T pixel circuit to which a pixel operation technique in accordance with a further embodiment of the present invention is suitably applied;
Figure 22 illustrates another example of a 3T pixel circuit to which the pixel operation technique associated with Figure 21 is suitably applied;
Figure 23A illustrates an example of signal waveforms applied to the pixel circuits of

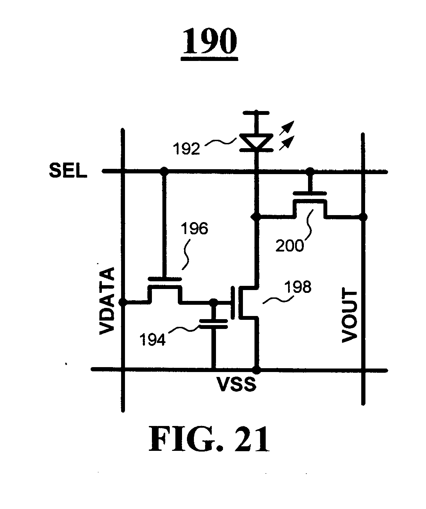

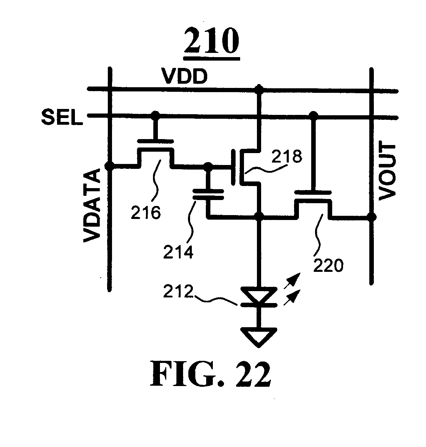

Figures 21 and 22 during an extraction operation;

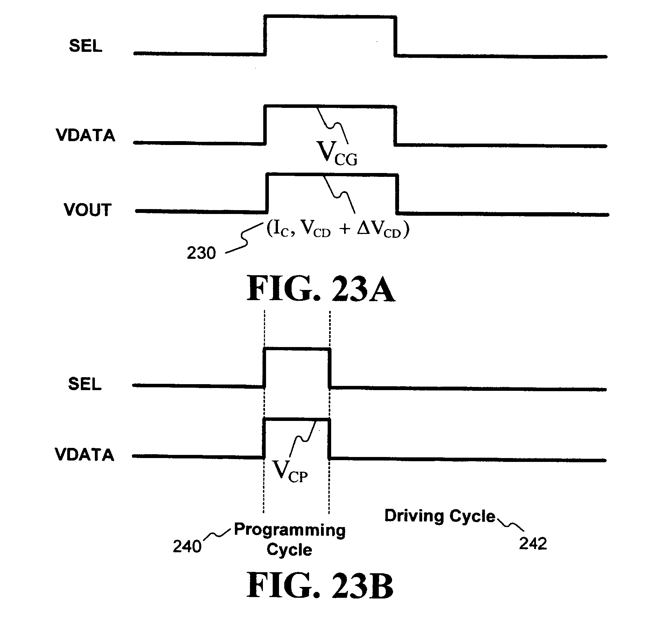

Figure 23B illustrates an example of signal waveforms applied to the pixel circuits of
Figures 21 and 22 during a normal operation;

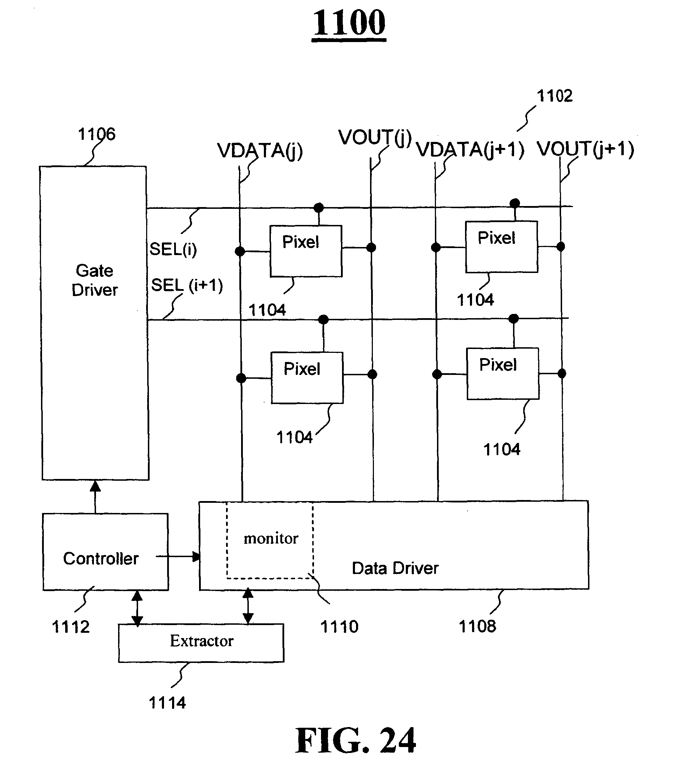

Figure 24 illustrates an example of a display system having the pixel circuit of Figure 21 or 22;

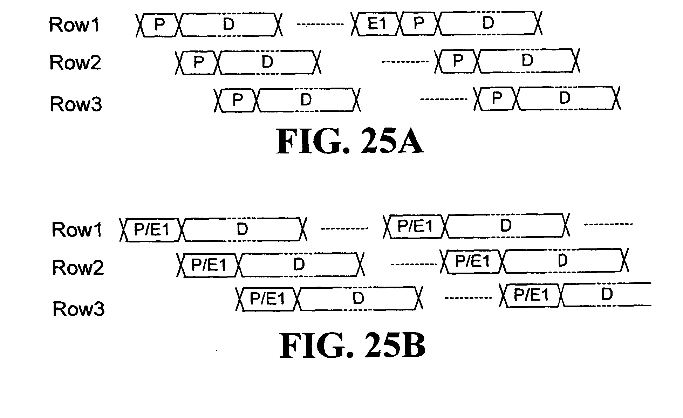

Figure 25A illustrates an example of normal and extraction cycles for driving the pixel array of Figure 24;
Figure 25B illustrates another example of normal and extraction cycles for driving the pixel array of Figure 24;

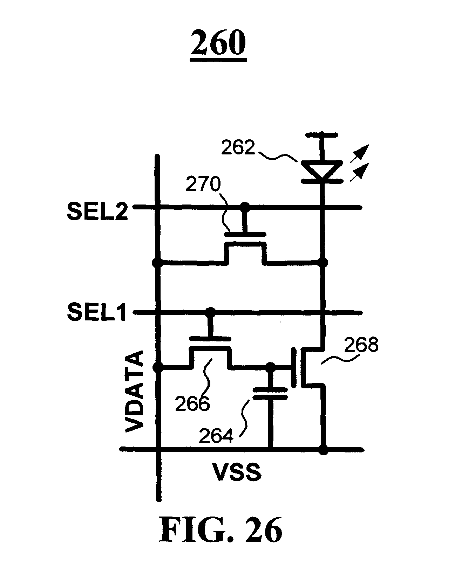

Figure 26 illustrates an example of a 3T pixel circuit to which a pixel operation technique is suitably applied;

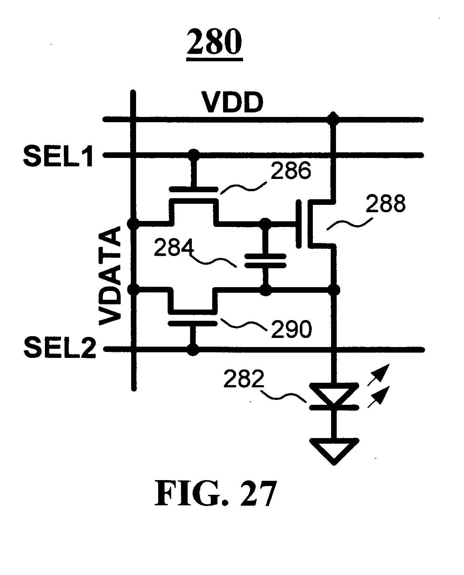

Figure 27 illustrates another example of a 3T pixel circuit to which the pixel operation technique associated with Figure 26 is suitably applied:

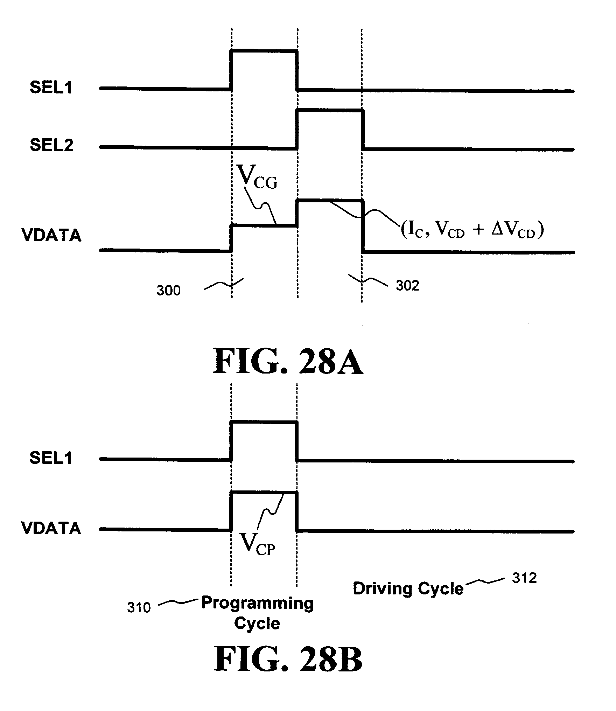

Figure 28A illustrates an example of signal waveforms applied to the pixel circuits of Figures 26 and 27 during an extraction operation;
Figure 28B illustrates an example of signal waveforms applied to the pixel circuits of Figures 26 and 27 during a normal operation;

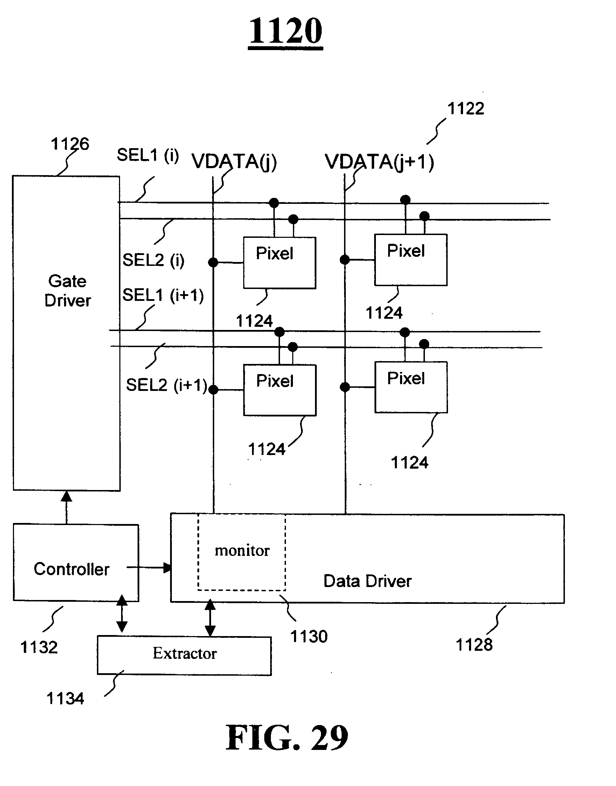

Figure 29 illustrates an example of a display system having the pixel circuit of Figure 26 or 27;

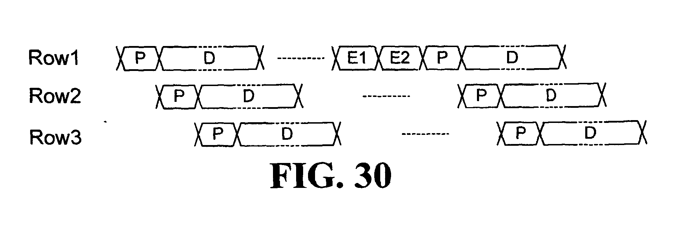

Figure 30 illustrates an example of normal and extraction cycles for driving the pixel array of Figure 29;

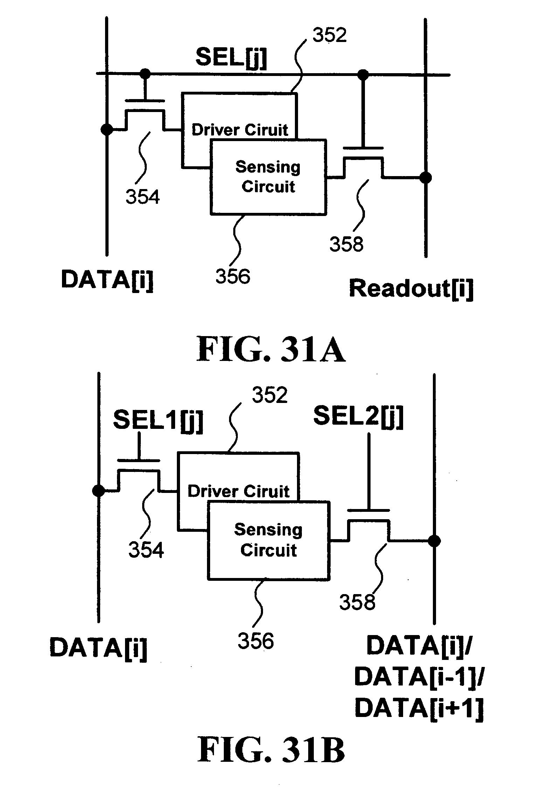

Figure 31A illustrates a pixel circuit with readout capabilities at thejth row and the ith column;
Figure 31B illustrates another pixel circuit with readout capabilities at the jth row and the ith column;

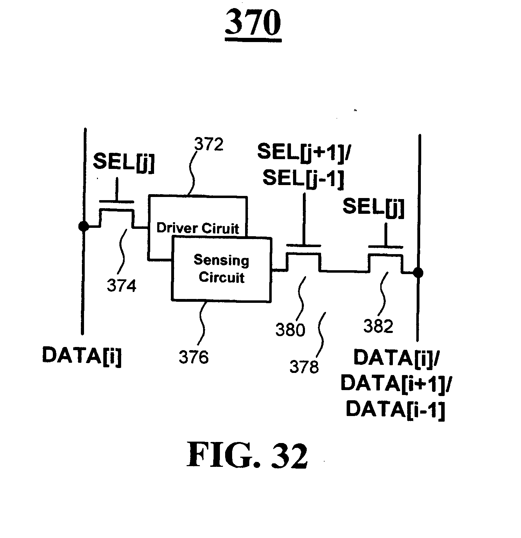

Figure 32 illustrates an example of a pixel circuit to which a driving technique is suitably applied;

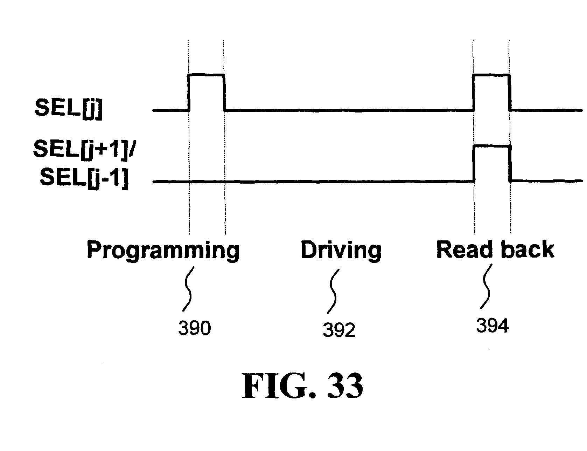

Figure 33 illustrates an example of signal waveforms applied to the pixel arrangement of Figure 32;

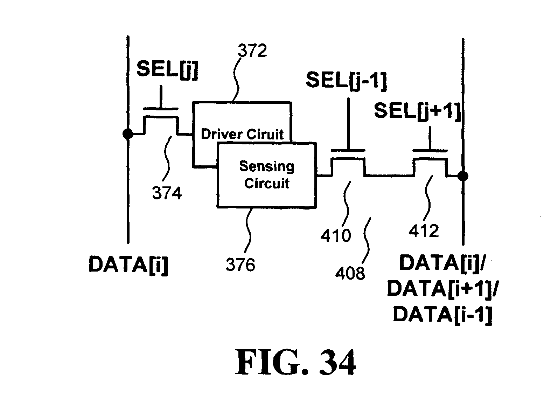

Figure 34 illustrates another example of a pixel circuit to which the driving technique associated with Figure 32 is suitably applied;

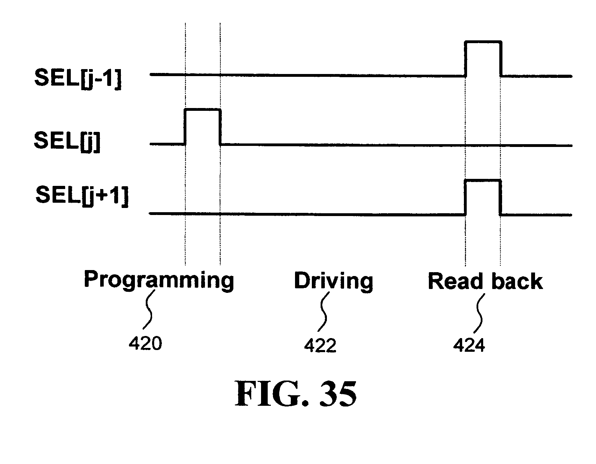

Figure 35 illustrates an example of signal waveforms applied to the pixel arrangement of Figure 34;

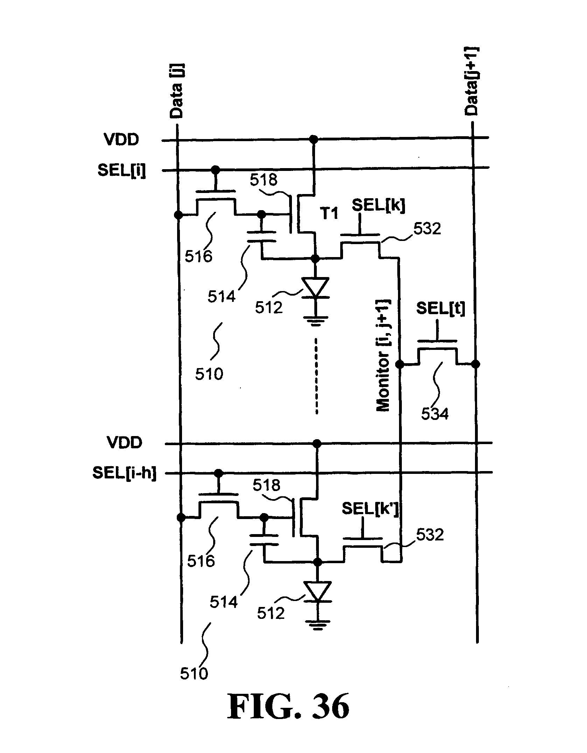

Figure 36 illustrates an example of a pixel array;

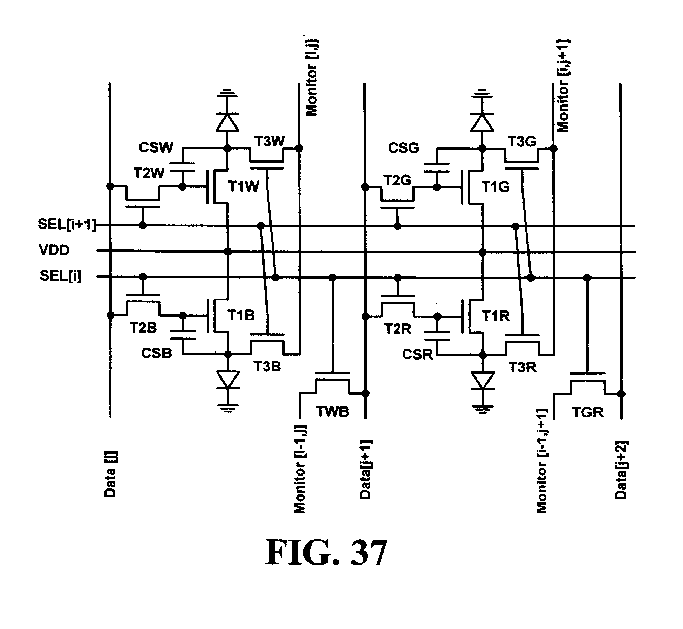

Figure 37 illustrates RGBW structure using the pixel array of Figure 36: and

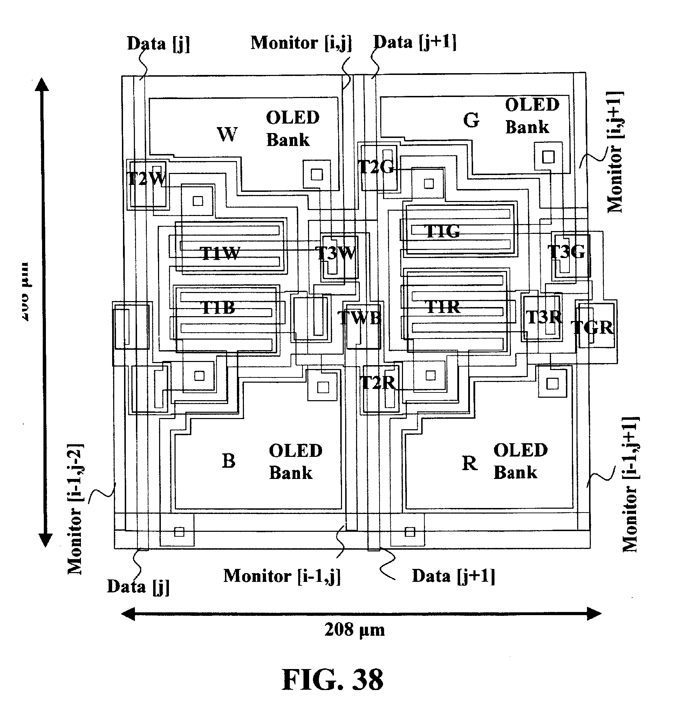

Figure 38 illustrates a layout for the pixel circuits of Figure 37.

### DETAILED DESCRIPTION

Embodiments of the present invention are described using a pixel circuit having a light emitting device (e.g., an organic light emitting diode (OLED)), and a plurality of transistors. The transistors in the pixel circuit or in display systems in the embodiments below may be n-type transistors, p-type transistors or combinations thereof. The transistors in the pixel circuit or in the display systems in the embodiments below may be fabricated using amorphous silicon, nano/micro crystalline silicon, poly silicon, organic semiconductors technologies (e.g. organic TFT), NMOS/PMOS technology or CMOS technology (e.g. MOSFET). A display having the pixel circuit may be a single color, multi-color or a fully color display, and may include one or more than one electroluminescence (EL) element (e.g., organic EL). The display may be an active matrix light emitting display (e.g., AMOLED). The display may be used in TVs, DVDs, personal digital assistants (PDAs), computer displays, cellular phones, or other applications. The display may be a flat panel.

In the description below, "pixel circuit" and "pixel" are used interchangeably. In the description below, "signal" and "line" may be used interchangeably. In the description below, the terms "line" and "node" may be used interchangeably. In the description, the terms "select line" and "address line" may be used interchangeably. In the description below, "connect (or connected)"and "couple (or coupled)" may be used interchangeably, and may be used to indicate that two or more elements are directly or indirectly in physical or electrical contact with each other. In the description, a pixel (circuit) in the ith row and the jth column may be referred to as a pixel (circuit) at position (i, j).

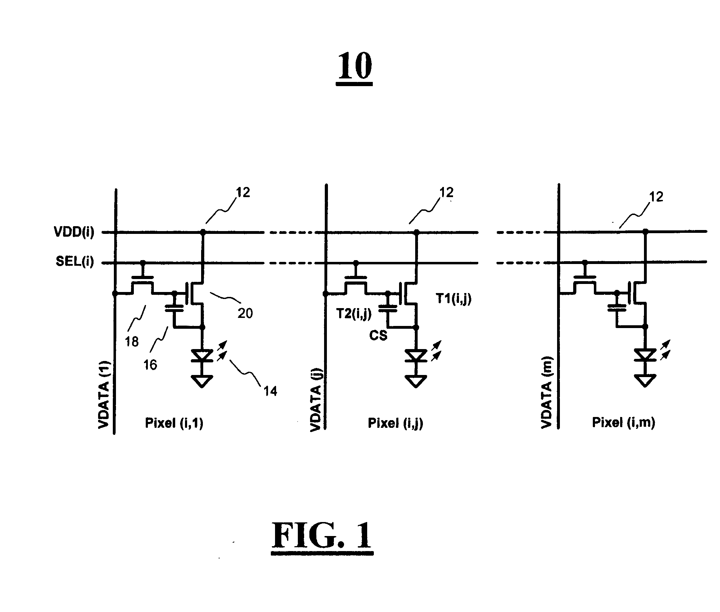

Figure 1 illustrates an example of a pixel array having a 2-transistor (2T) pixel circuit to which a pixel operation technique in accordance with an example is suitably applied. The pixel array 10 of Figure 1 includes a plurality of pixel circuits 12 arranged in "n" rows and "m" columns. In Figure 1, the pixel circuits 12 in the ith row are shown.

Each pixel circuit 12 includes an OLED 14, a storage capacitor 16, a switch transistor 18, and a drive transistor 20. The drain terminal of the drive transistor 20 is connected to a power supply line for the corresponding row (e.g., VDD(i)), and the source terminal of the drive transistor 20 is connected to the OLED 14. One terminal of the switch transistor 18 is connected to a data line for the corresponding column (e.g., VDATA(l), ... , or VDATA (m)), and the other terminal of the switch transistor 18 is connected to the gate terminal of the drive transistor 20. The gate terminal of the switch transistor 18 is connected to a select line for the corresponding row (e.g., SEL(i)). One terminal of the storage capacitor 16 is connected to the gate terminal of the drive transistor 20, and the other terminal of the storage capacitor 16 is connected to the OLED 14 and the source terminal of the drive transistor 20. The OLED 14 is connected between a power supply (e.g., ground) and the source terminal of the drive transistor 20. The aging of the pixel circuit 12 is extracted by monitoring the voltage of the power supply line VDD(i), as described below.

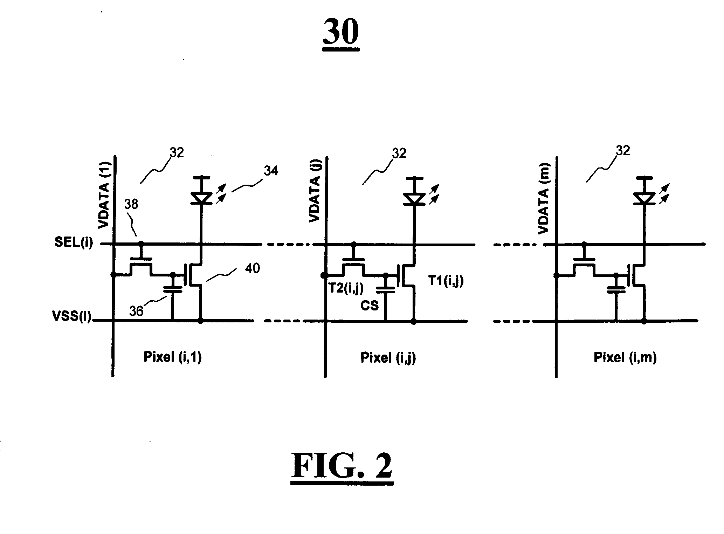

Figure 2 illustrates another example of a pixel array having a 2T pixel circuit to which the pixel operation technique associated with Figure 1 is suitably applied. The pixel array 30 of Figure 2 is similar to the pixel array 10 of Figure 1. The pixel circuit array 30 includes a plurality of pixel circuits 32 arranged in "n" rows and "m" columns. In Figure 2, the pixel circuits 32 in the ith row are shown.

Each pixel circuit 32 includes an OLED 34, a storage capacitor 36, a switch transistor 38, and a drive transistor 40. The OLED 34 corresponds to the OLED 14 of Figure 1. The storage capacitor 36 corresponds to the storage capacitor 16 of Figure 1. The switch transistor 38 corresponds to the switch transistor 18 of Figure 1. The drive transistor 40 corresponds to the drive transistor 20 of Figure 1.

The source terminal of the drive transistor 40 is connected to a power supply line for the corresponding row (e.g., VSS(i)), and the drain terminal of the drive transistor 40 is connected to the OLED 34. One terminal of the switch transistor 38 is connected to a data line for the corresponding column (e.g., VDATA(l), ..., or VDATA (m)), and the other terminal of the switch transistor 38 is connected to the gate terminal of the drive transistor 40. One terminal of the storage capacitor 34 is connected to the gate terminal of the drive transistor 40, and the other terminal of the storage capacitor 34 is connected to the corresponding power supply line (e.g., VSS(i)). The OLED 34 is connected between a power supply and the drain terminal of the drive transistor 40. The aging of the pixel circuit is extracted by monitoring the voltage of the power supply line VSS(i), as described below.

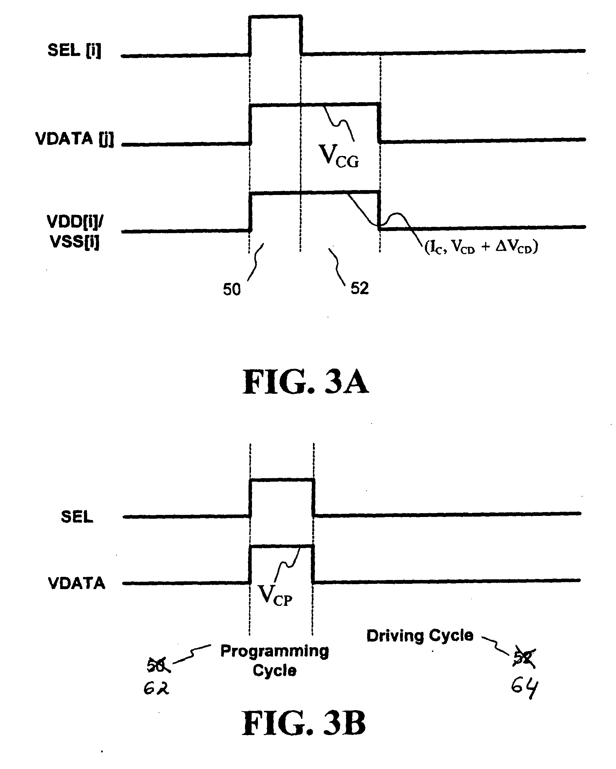

Figure 3A illustrates an example of signal waveforms applied to the pixel circuits of Figures 1 and 2 during an extraction operation. Figure 3B illustrates an example of signal waveforms applied to the pixel circuits of Figures 1 and 2 during a normal operation. In Figure 3A, VDD(i) is a power supply line/signal corresponding to VDD(i) of Figure 1, and VSS(i) is a power supply line/signal corresponding to VSS(i) of Figure 2. "Ic" is a constant current applied to VDD (i) of the pixel at position (i, j), which is being calibrated. The voltage generated on VDD (i) line as a result of the current Ic is (V_{CD}+ΔV_{CD}) where V_{CD} is the DC biasing point of the circuit and ΔV_{CD} is the amplified shift in the OLED voltage and threshold voltage of drive transistor (20 of Figure 1 or 40 of Figure 2).

Referring to Figures 1, 2 and 3A, the aging of the pixel at position (i, j) is extracted by monitoring the voltage of the power supply line (VDD (i) of Figure 1 or VSS(i) of Figure 2). The operation of Figure 3A for the pixel at position (i, j) includes first and second extraction cycles 50 and 52. During the first extraction cycle 50, the gate terminal of the drive transistor (20 of Figure 1 or 40 of Figure 2) in the pixel at position (i, j) is charged to a calibration voltage V_{CG}. This calibration voltage V_{CG} includes the aging prediction, calculated based on the previous aging data, and a bias voltage. Also, the other pixel circuits in the ith row are programmed to zero during the first extraction cycle.

During the second extraction cycle 52, SEL(i) goes to zero and so the gate voltage of the drive transistor (20 of Figure 1 or 40 of Figure 2) in the pixel at position (i, j) is affected by the dynamic effects such as charge injection and clock feed-through. During this cycle, the drive transistor (20 of Figure 1 or 40 of Figure 2) acts as an amplifier since it is biased with a constant current through the power supply line for the ith row (VDD(i) of Figure 1 or VSS(i) of Figure 2). Therefore, the effects of shift in the threshold voltage (VT) of the drive transistor (20 of Figure 1 or 40 of Figure 2) in the pixel at position (i, j) is amplified, and the voltage of the power supply line (VDD(i) of Figure 1 or VSS(i) of Figure 2) changes accordingly. Therefore, this method enables extraction of very small amount of VT shift resulting in highly accurate calibration. The change in VDD (i) or VSS(i) is monitored. Then, the change(s) in VDD(i) or VSS(i) is used for calibration of programming data.

Referring to Figures 1, 2 and Figure 3B, the normal operation for the pixel at position (i, j) includes a programming cycle 62 and a driving cycle 64. During the programming cycle 62, the gate terminal of the drive transistor (20 of Figure 1 or 40 of Figure 2) in the pixel at position (i, j) is charged to a calibrated programming voltage V_{CP} using the monitoring result (e.g., change(s) of VDD or VSS). This voltage Vcp is defined by the gray scale and the aging of the pixel (e.g., it is the sum of a voltage related to a gray scale and the aging extracted during the calibration cycles). Next, during the driving cycle 64, the select line SEL(i) is low and the drive transistor (20 of Figure 1 or 40 of Figure 2) in the pixel at position (i, j) provides current to the OLED (14 of Figure 1 or 34 of Figure 2) in the pixel at position (i, j).

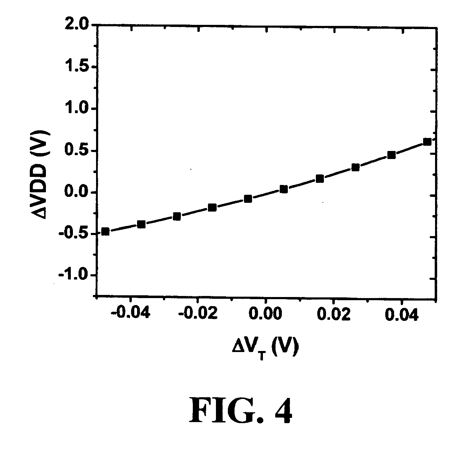

Figure 4 illustrates the effect of shift in the threshold voltage of the drive transistor (VT shift) on the voltage of the power supply line VDD during the extraction cycles of Figure 3A. It is apparent to one of ordinary skill in the art that the drive transistor can provide a reasonable gain so that makes the extraction of small VT shift possible.

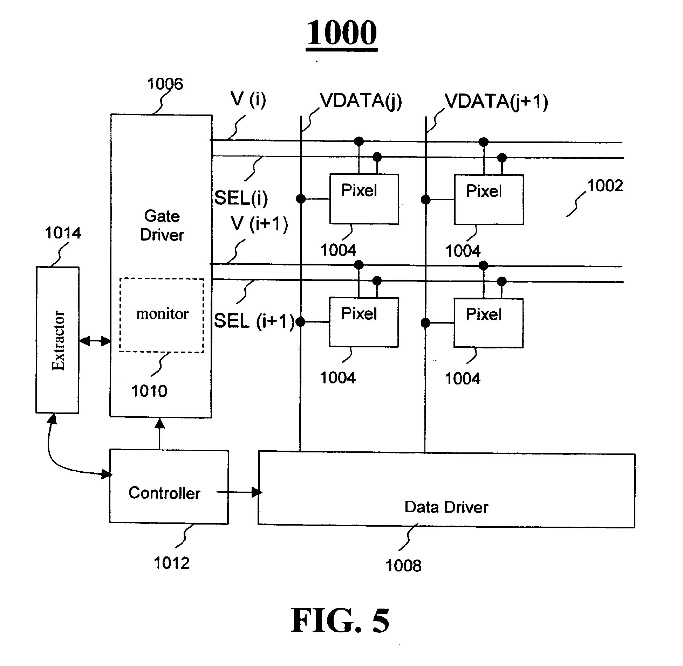

Figure 5 illustrates an example of a display system having the pixel arrays of Figures 1 and 2. The display system 1000 of Figure 5 includes a pixel array 1002 having a plurality of pixels 1004. In Figure 5, four pixels 1004 are shown. However, the number of the pixels 1004 may vary in dependence upon the system design, and does not limited to four. The pixel 1004 may be the pixel circuit 12 of Figure 1 or the pixel circuit 32 of Figure 2. The pixel array 1002 is an active matrix light emitting display, and may form an AMOLED display.

SEL(k) (k=i, i+1) is a select line for selecting the kth row, and corresponds to SEL(i) of Figures 1 and 2. V(k) is a power supply line and corresponds to VDD(j) of Figure 1 and VSS(j) of Figure 2. VDATA(l) (l=j, j+1) is a data line and corresponds to one of VDATA (1), ..., VDATA(m) of Figures 1 and 2. SEL(k) and V(k) are shared between common row pixels in the pixel array 1002. VDATA(l) is shared between common column pixels in the pixel array 1002.

A gate driver 1006 drives SEL(k) and V(k). The gate driver 1006 includes an address driver for providing address signals to SEL (k). The gate driver 1006 includes a monitor 1010 for driving V(k) and monitoring the voltage of V(k). V(k) is appropriately activated for the operations of Figure 3A and 3B. A data driver 1008 generates a programming data and drives VDATA(l). Extractor block 1014 calculates the aging of the pixel based on the voltage generated on VDD(i). VDATA(l) is calibrated using the monitoring result (i.e., the change of the data line V(k)). The monitoring result may be provided to a controller 1012. The gate driver 1006, the controller 1012, the extractor 1014, or a combination thereof may include a memory for storing the monitoring result. The controller 1012 controls the drivers 1006 and 1008 and the extractor 1014 to drive the pixels 1004 as described above. The voltages V_{CG}, V_{CP} of Figure 3A and 3B are generated using the column driver.

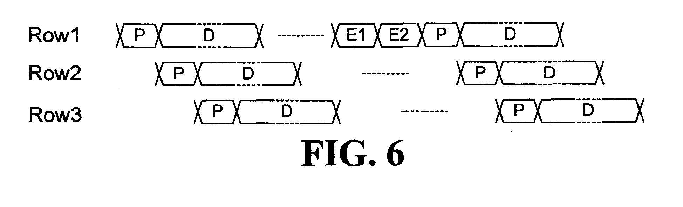

Figure 6 illustrates an example of normal and extraction cycles for driving the pixel array 1002 of Figure 5. In Figure 6, each of ROWi (i=1, 2, ..) represents the ith row; "P" represents a programming cycle and corresponds to 60 of Figure 3B; "D" represents a driving cycle and corresponds to 62 of Figure 3B; "E1" represents a first extraction cycle and corresponds to 50 of Figure 3A; and "E2" represents a second extraction cycle and corresponds to 52 of Figure 3A. The extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality.

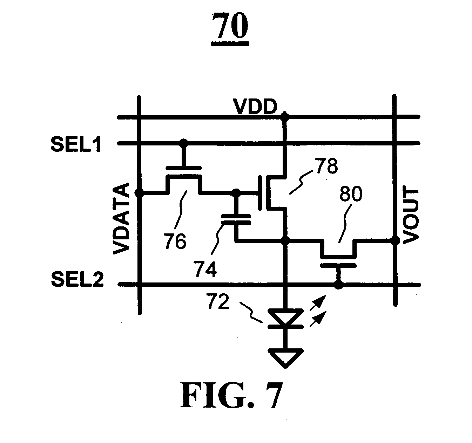

Figure 7 illustrates an example of a 3-transistor (3T) pixel circuit to which a pixel operation technique in accordance with an embodiment of the present invention is suitably applied. The pixel circuit 70 of Figure 7 includes an OLED 72, a storage capacitor 74, a switch transistor 76, and a drive transistor 78. The pixel circuit 70 forms an AMOLED display.

The drain terminal of the drive transistor 78 is connected to a power supply line VDD, and the source terminal of the drive transistor 78 is connected to the OLED 72. One terminal of the switch transistor 76 is connected to a data line VDATA, and the other terminal of the switch transistor 76 is connected to the gate terminal of the drive transistor 78. The gate terminal of the switch transistor 76 is connected to a first select line SEL1. One terminal of the storage capacitor 74 is connected to the gate terminal of the drive transistor 78, and the other terminal of the storage capacitor 74 is connected to the OLED 72 and the source terminal of the drive transistor 78.

A sensing transistor 80 is provided to the pixel circuit 70. The transistor 80 may be included in the pixel circuit 70. One terminal of the transistor 80 is connected to an output line VOUT, and the other terminal of the transistor 80 is connected to the source terminal of the drive transistor 78 and the OLED 72. The gate terminal of the transistor 80 is connected to a second select line SEL2.

The aging of the pixel circuit 70 is extracted by monitoring the voltage of the output line VOUT. In one example, VOUT may be provided separately from VDATA. In another example, VOUT may be a data line VDATA for a physically adjacent column (row). SEL1 is used for programming, while SEL1 and SEL2 are used for extracting pixel aging.

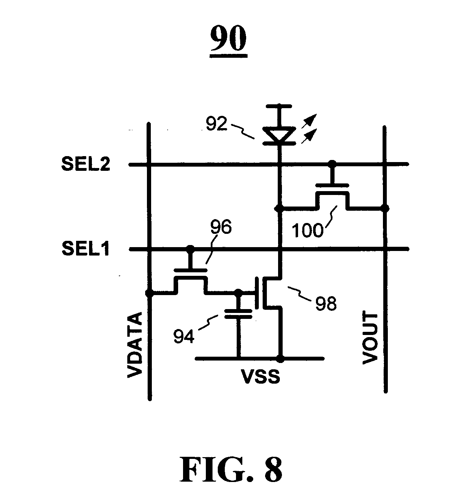

Figure 8 illustrates another example of a 3T pixel circuit to which the pixel operation technique associated with Figure 7 is suitably applied. The pixel circuit 90 of Figure 8 includes an OLED 92, a storage capacitor 94, a switch transistor 96, and a drive transistor 98. The OLED 92 corresponds to the OLED 72 of Figure 7. The storage capacitor 94 corresponds to the storage capacitor 74 of Figure 7. The transistors 96 and 98 correspond to the transistors 76 and 78 of Figure 7. The pixel circuit 90 forms an AMOLED display.

The source terminal of the drive transistor 98 is connected to a power supply line VSS, and the drain terminal of the drive transistor 98 is connected to the OLED 92. The switch transistor 96 is connected between a data line VDATA and the gate terminal of the drive transistor 98. The gate terminal of the switch transistor 96 is connected to a first select line SEL1. One terminal of the storage capacitor 94 is connected to the gate terminal of the drive transistor 98, and the other terminal of the storage capacitor 94 is connected to VSS.

A sensing transistor 100 is provided to the pixel circuit 90. The transistor 100 may be included in the pixel circuit 90. One terminal of the transistor 100 is connected to an output line VOUT, and the other terminal of the transistor 100 is connected to the drain terminal of the drive transistor 98 and the OLED 92. The gate terminal of the transistor 100 is connected to a second select line SEL2.

The aging of the pixel circuit 90 is extracted by monitoring the voltage of the output line VOUT. In one example, VOUT may be provided separately from VDATA. In another example, VOUT may be a data line VDATA for a physically adjacent column (row). SEL1 is used for programming, while SEL1 and SEL2 are used for extracting pixel aging.

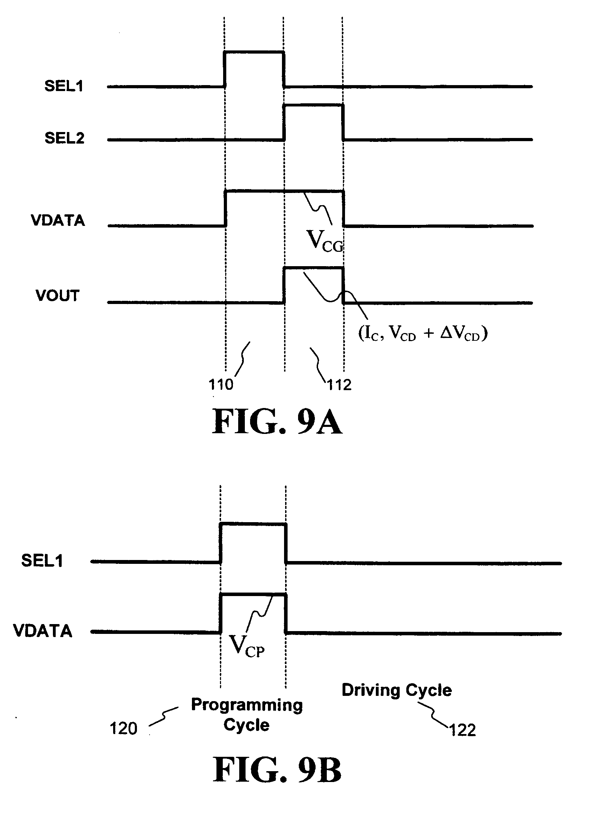

Figure 9A illustrates an example of signal waveforms applied to the pixel circuits of Figures 7 and 8 during an extraction operation. Figure 9B illustrates an example of signal waveforms applied to the pixel circuits of Figures 7 and 8 during a normal operation.

Referring to 7, 8 and Figures 9A, the extraction operation for the pixel at position (i, j) includes first and second extraction cycles 110 and 112. During the first extraction cycle 110, the gate terminal of the drive transistor (78 of Figure 7 or 98 of Figure 8) is charged to a calibration voltage V_{CG}. This calibration voltage V_{CG} includes the aging prediction, calculated based on the previous aging data. During the second extraction cycle 112, the first select line SEL1 goes to zero, and so the gate voltage of the drive transistor (78 of Figure 7 or 98 of Figure 8) is affected by the dynamic effects including the charge injection and clock feed-through. During the second extraction cycle 112, the drive transistor (78 of Figure 7 or 98 of Figure 8) acts as an amplifier since it is biased with a constant current (Ic) through VOUT. The voltage developed on VOUT as a result of current Ic applied to it is (V_{CD}+ΔV_{CD}). Therefore, the aging of the pixel is amplified, and the voltage of the VOUT changes accordingly. Therefore, this method enables extraction of very small amount of voltage threshold (VT) shift resulting in highly accurate calibration. The change in VOUT is monitored. Then, the change(s) in VOUT is used for calibration of programming data.

Also, applying a current/voltage to the OLED during the extraction cycle, the voltage/current of the OLED can be extracted, and the system determines the aging factor of the OLED and uses it for more accurate calibration of the luminance data.

Referring to 7, 8 and 9B, the normal operation for the pixel at position (i, j) includes a programming cycle 120 and a driving cycle 122. During the programming cycle 120, the gate terminal of the drive transistor (78 of Figure 7 or 98 of Figure 8) is charged to a calibrated programming voltage V_{CP} using the monitoring result (e.g., the changes of VOUT). Next, during the driving cycle 122, the select line SEL1 is low and the drive transistor (78 of Figure 7 or 98 of Figure 8) provides current to the OLED (72 of Figure 7. or 92 of Figure 8).

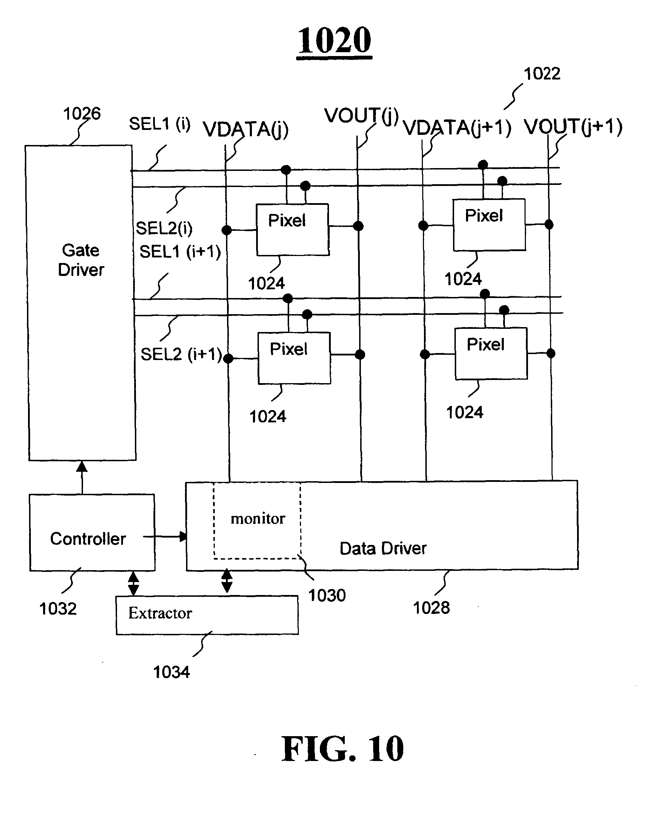

Figure 10 illustrates an example of a display system having the pixel circuit of Figure 7 or 8. The display system 1020 of Figure 10 includes a pixel array 1022 having a plurality of pixels 1004 arranged in row and column. In Figure 10, four pixels 1024 are shown. However, the number of the pixels 1024 may vary in dependence upon the system design, and does not limited to four. The pixel 1024 may be the pixel circuit 70 of Figure 7 or the pixel circuit 90 of Figure 8. The pixel array 1022 is an active matrix light emitting display, and may be an AMOLED display.

SEL1(k) (k=i, i+1) is a first select line for selecting the kth row, and corresponds to SEL1 of Figures 7 and 8. SEL2(k) (k=i, i+1) is a second select line for selecting the kth row, and corresponds to SEL2 of Figures 7 and 8. VOUT(l) (l=j, j+1) is an output line for the lth column, and corresponds to VOUT of Figures 7 and 8. VDATA(l) is a data line for the lth column, and corresponds to VDATA of Figures 7 and 8.

A gate driver 1026 drives SEL1(k) and SEL2(k). The gate driver 1026 includes an address driver for providing address signals to SEL1(k) and SEL2(k). A data driver 1028 generates a programming data and drives VDATA(l). The data driver 1028 includes a monitor 1030 for driving and monitoring the voltage of VOUT(l). Extractor block 1034 calculates the aging of the pixel based on the voltage generated on VOUT(i). VDATA(l) and VOUT (l) are appropriately activated for the operations of Figure 9A and 9B. VDATA(l) is calibrated using the monitoring result (i.e., the change of VOUT(l)). The monitoring result may be provided to a controller 1032. The data driver 1028, the controller 1032, the extractor 1034, or a combination thereof may include a memory for storing the monitoring result. The controller 1032 controls the drivers 1026 and 1028 and the extractor 1034 to drive the pixels 1004 as described above.

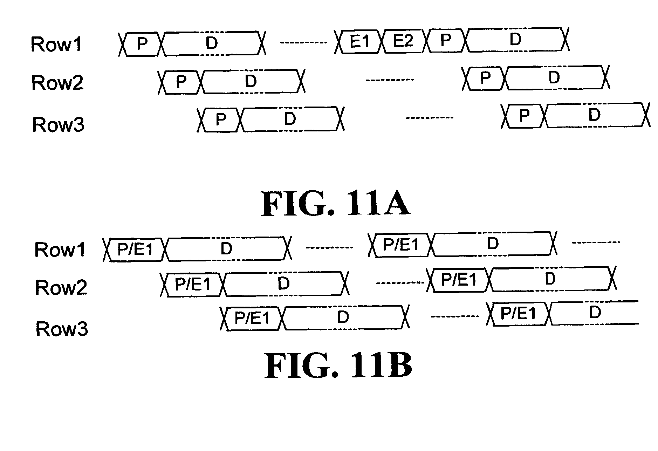

Figure 11A and 11B illustrate two examples of normal and extraction cycles for driving the pixel array of Figure 10. In Figure 11A and 11B, each of ROWi (i=1, 2, ..) represents the ith row; "P" represents a programming cycle and corresponds to 120 of Figure 9B; "D" represents a driving cycle and corresponds to 122 of Figure 9B; "E1" represents a first extraction cycle and corresponds to 110 of Figure 9A: and "E2" represents a second extraction cycle and corresponds to 112 of Figure 9A. In Figure 11A. the extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality. Figure 11B shows a case in which one can do the extraction in parallel with programming cycle.

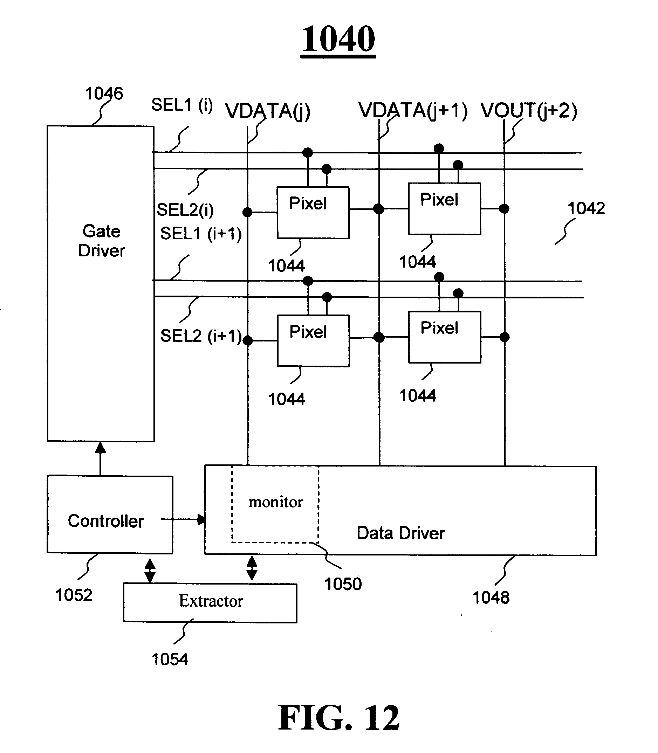

Figure 12 illustrates another example of a display system having the pixel circuit of Figure 7 or 8. The display system 1040 of Figure 12 includes a pixel array 1042 having a plurality of pixels 1044 arranged in row and column. The display system 1040 is similar to the display system 1020 of Figure 10. In Figure 12, data line VDATA (j+1) is used as an output line VOUT(j) for monitoring the ageing of pixel.

A gate driver 1046 is the same or similar to the gate driver 1026 of Figure 10. The gate driver 1046 includes an address driver for providing address signals to SEL1(k) and SEL2(k). A data driver 1048 generates a programming data and drives VDATA(l). The data driver 1048 includes a monitor 1050 for monitoring the voltage of VDATA(l). VDATA(l) is appropriately activated for the operations of Figure 9A and 9B. Extractor block 1054 calculates the aging of the pixel based on the voltage generated on VDATA. VDATA(l) is calibrated using the monitoring result (i.e., the change of VDATA(l)). The monitoring result may be provided to a controller 1052. The data driver 1048, the controller 1052, the extractor 1054, or a combination thereof may include a memory for storing the monitoring result. The controller 1052 controls the drivers 1046 and 1048 and the extractor 1054 to drive the pixels 1004 as described above.

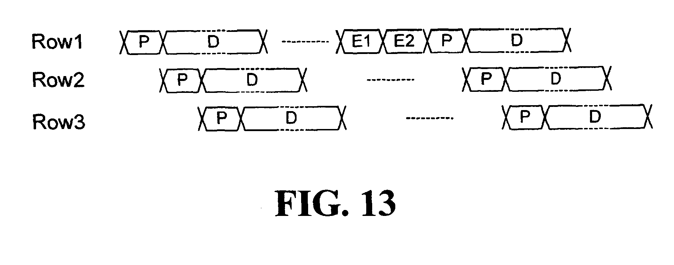

Figure 13 illustrates an example of normal and extraction cycles for driving the pixel array 1042 of Figure 12. In Figure 13, each of ROWi (i=1, 2, ..) represents the ith row; "P" represents a programming cycle and corresponds to 120 of Figure 9B; "D" represents a driving cycle and corresponds to 122 of Figure 9B; "E1" represents a first extraction cycle and corresponds to 110 of Figure 9A; and "E2" represents a second extraction cycle and corresponds to 112 of Figure 9A. The extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality.

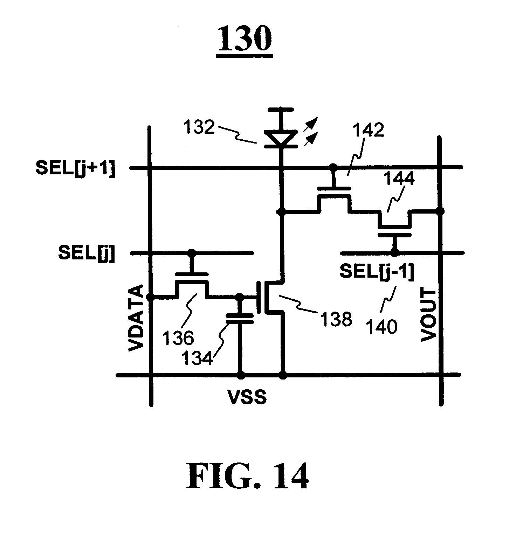

Figure 14 illustrates an example of a 4-transistor (4T) pixel circuit to which a pixel operation technique in accordance with a further embodiment of the present invention is suitably applied. The pixel circuit 130 of Figure 14 includes an OLED 132, a storage capacitor 134, a switch transistor 136, and a drive transistor 138. The pixel circuit 130 forms an AMOLED display.

The drain terminal of the drive transistor 138 is connected to the OLED 132, and the source terminal of the drive transistor 138 is connected to a power supply line VSS (e.g., ground). One terminal of the switch transistor 136 is connected to a data line VDATA, and the other terminal of the switch transistor 136 is connected to the gate terminal of the drive transistor 138. The gate terminal of the switch transistor 136 is connected to a select line SEL[j]. One terminal of the storage capacitor 134 is connected to the gate terminal of the drive transistor 138, and the other terminal of the storage capacitor 134 is connected to VSS.

A sensing network 140 is provided to the pixel circuit 130. The network 140 may be included in the pixel circuit 130. The circuit 140 includes transistors 142 and 144. The transistors 142 and 144 are connected in series between the drain terminal of the drive transistor 138 and an output line VOUT. The gate terminal of the transistor 142 is connected to a select line SEL[j+1]. The gate terminal of the transistor 144 is connected to a select line SEL[j-1].

The select line SEL[k] (k=j-1, j, j+1) may be an address line for the kth row of a pixel array. The select line SEL[j-1] or SEL[j+1] may be replaced with SEL[j] where SEL[j] is ON when both of SEL[j-1] and SEL[j+1] signals are ON.

The aging of the pixel circuit 130 is extracted by monitoring the voltage of the output line VOUT. In one example, VOUT may be provided separately from VDATA. In another example, VOUT may be a data line VDATA for a physically adjacent column (row).

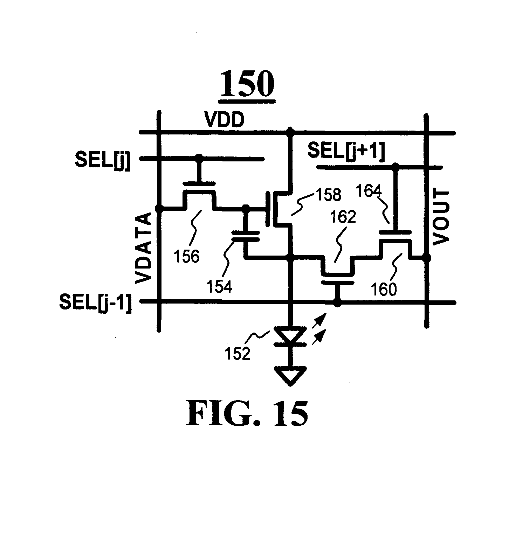

Figure 15 illustrates another example of a 4T pixel circuit to which the pixel operation technique associated with Figure 14 is suitably applied. The pixel circuit 150 of Figure 15 includes an OLED 152, a storage capacitor 154, a switch transistor 156, and a drive transistor 158. The pixel circuit 150 forms an AMOLED display. The OLED 152 corresponds to the OLED 132 of Figure 14. The storage capacitor 154 corresponds to the storage capacitor 134 of Figure 14. The transistors 156 and 158 correspond to the transistors 136 and 138 of Figure 14.

The source terminal of the drive transistor 158 is connected to the OLED 152, and the drain terminal of the drive transistor 158 is connected to a power supply line VDD. The switch transistor 156 is connected between a data line VDATA and the gate terminal of the drive transistor 158. One terminal of the storage capacitor 154 is connected to the gate terminal of the drive transistor 158, and the other terminal of the storage capacitor 154 is connected to the OLED 152 and the source terminal of the drive transistor 158.

A sensing network 160 is provided to the pixel circuit 150. The network 160 may be included in the pixel circuit 150. The circuit 160 includes transistors 162 and 164. The transistors 162 and 164 are connected in series between the source terminal of the drive transistor 158 and an output line VOUT. The gate terminal of the transistor 162 is connected to a select line SEL[j-1]. The gate terminal of the transistor 164 is connected to a select line SEL[j+1]. The transistors 162 and 164 correspond to the transistors 142 and 144 of Figure 14.

The aging of the pixel circuit 150 is extracted by monitoring the voltage of the output line VOUT. In one example, VOUT may be provided separately from VDATA. In another example, VOUT may be a data line VDATA for a physically adjacent column (row).

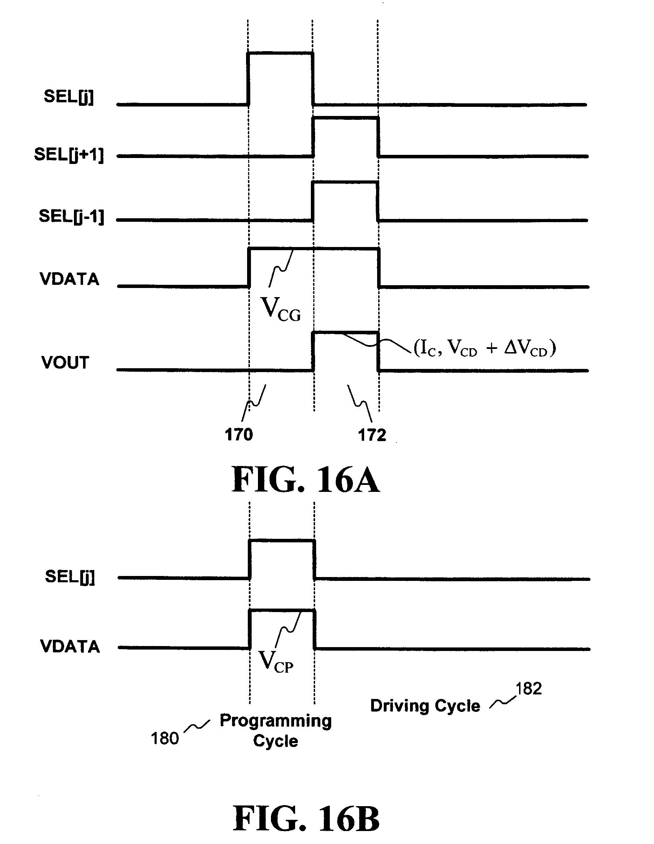

Figure 16A illustrates an example of signal waveforms applied to the pixel circuits of Figures 14 and 15 during an extraction operation. Figure 16B illustrates an example of signal waveforms applied to the pixel circuits of Figures 14 and 15 during a normal operation.

Referring to 14, 15 and Figures 16A, the extraction operation for the pixel at position (i, j) includes first and second extraction cycles 170 and 172. During the first extraction cycle 170, the gate terminal of the drive transistor (138 of Figure 14 or 158 of Figure 15) is charged to a calibration voltage V_{CG}. This calibration voltage V_{CG} includes the aging prediction, calculated based on the previous aging data. During the second extraction cycle 172, the select line SEL[i] goes to zero, and so the gate voltage of the drive transistor (138 of Figure 14 or 158 of Figure 15) is affected by the dynamic effects including the charge injection and clock feed-through. During the second extraction cycle 172, the drive transistor (138 of Figure 14 or 158 of Figure 15) acts as an amplifier since it is biased with a constant current through VOUT. The voltage developed on VOUT as a result of current Ic applied to it is (V_{CD}+ΔV_{CD}). Therefore, the aging of the pixel is amplified, and change the voltage of the VOUT. Therefore, this method enables extraction of very small amount of voltage threshold (VT) shift resulting in highly accurate calibration. The change in VOUT is monitored. Then, the change(s) in VOUT is used for calibration of programming data.

Also, applying a current/voltage to the OLED during the extraction cycle, the sytem can extract the voltage/current of the OLED and determines the aging factor of the OLED and use it for more accurate calibration of the luminance data.

Referring to 14, 15 and 16B, the normal operation for the pixel at position (i, j) includes a programming cycle 180 and a driving cycle 182. During the programming cycle 180, the gate terminal of the drive transistor (138 of Figure 14 or 158 of Figure 15) is charged to a calibrated programming voltage V_{CP} using the monitoring result (e.g., the changes of VOUT). During the driving cycle 182, the select line SEL[i] is low and the drive transistor (138 of Figure 14 or 158 of Figure 15) provides current to the OLED (142 of Figure 14 or 152 of Figure 15).

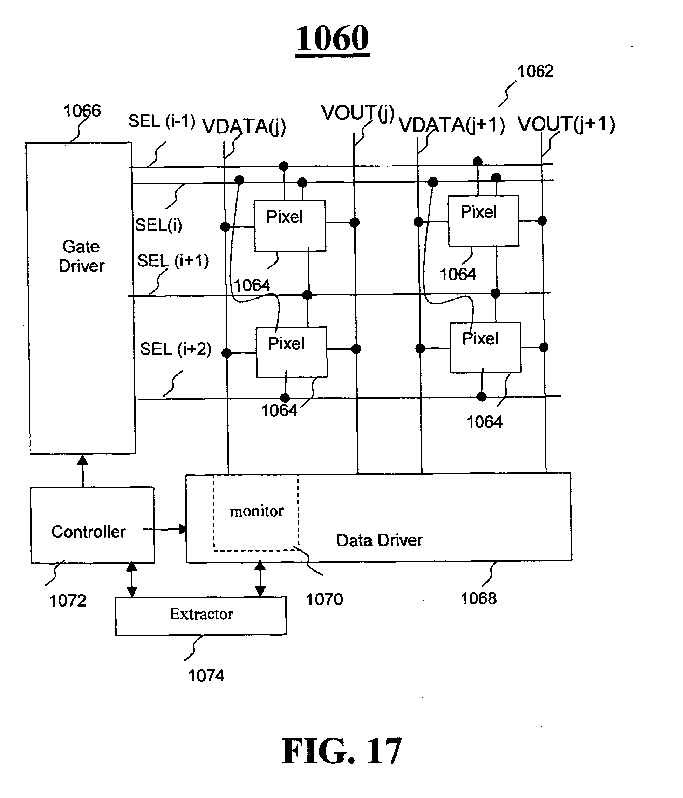

Figure 17 illustrates an example of a display system having the pixel circuit of Figure 14 or 15 where VOUT is separated from VDATA. The display system 1060 of Figure 17 is similar to the display system 1020 of Figure 10. The display system 1060 includes a pixel array having a plurality of pixels 1064 arranged in row and column. In Figure 17, four pixels 1064 are shown. However, the number of the pixels 1064 may vary in dependence upon the system design, and does not limited to four. The pixel 1064 may be the pixel circuit 130 of Figure 14 or the pixel circuit 150 of Figure 15. The pixel array of Figure 13 is an active matrix light emitting display, and may be an AMOLED display.

SEL1(k) (k=i-1, i, i+1, i+2) is a select line for selecting the kth row, and corresponds to SEL[j-1], SEL[j] and SEL[j+1] of Figures 14 and 15. VOUT(l) (l=j, j+1) is an output line for the lth column, and corresponds to VOUT of Figures 14 and 15. VDATA(l) is a data line for the lth column, and corresponds to VDATA of Figures 14 and 15.

A gate driver 1066 drives SEL(k). The gate driver 1066 includes an address driver for providing address signals to SEL(k). A data driver 1068 generates a programming data and drives VDATA(l). The data driver 1068 includes a monitor 1070 for driving and monitoring the voltage of VOUT(l). Extractor block 1074 calculates the aging of the pixel based on the voltage generated on VOUT(l). VDATA(l) and VOUT (1) are appropriately activated for the operations of Figure 16A and 16B. VDATA(l) is calibrated using the monitoring result (i.e., the change of VOUT(l)). The monitoring result may be provided to a controller 1072. The data driver 1068, the controller 1072, the extractor 1074, or a combination thereof may include a memory for storing the monitoring result. The controller 1072 controls the drivers 1066 and 1068 and the extractor 1074 to drive the pixels 1064 as described above.

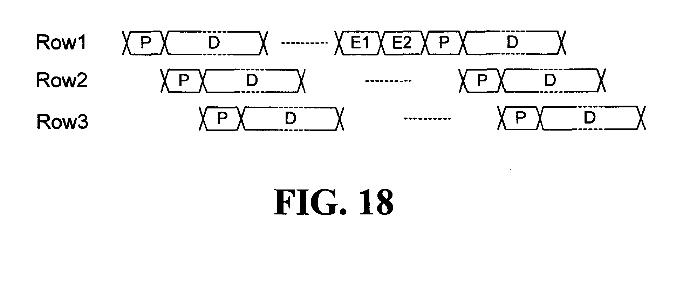

Figure 18 illustrates an example of the normal and extraction cycles for driving the pixel array of Figure 17. In Figure 18, each of ROWi (i=1, 2, ..) represents the ith row; "P" represents a programming cycle and corresponds to 180 of Figure 16B; "D" represents a driving cycle and corresponds to 182 of Figure 16B; "E1" represents the first and second extraction cycle and corresponds to 170 of Figure 16A; and "E2" represents a second extraction cycle and corresponds to 172 of Figure 16A. The extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality.

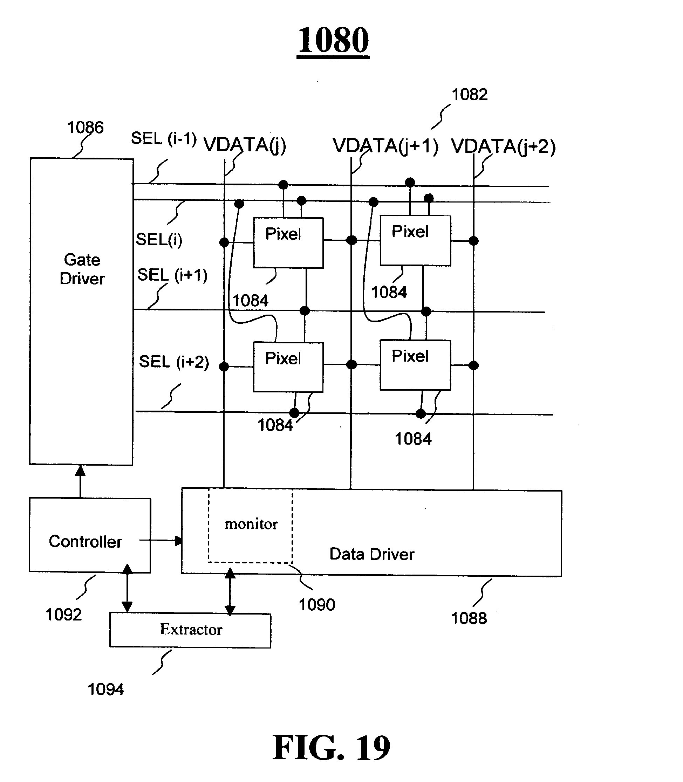

Figure 19 illustrates another example of a display system having the pixel circuit of Figure 14 or 15 where VDATA is used as VOUT. The display system 1080 of Figure 19 is similar to the display system 1040 of Figure 12. The display system 1080 includes a pixel array having a plurality of pixels 1084 arranged in row and column. In Figure 19, four pixels 1084 are shown. However, the number of the pixels 1084 may vary in dependence upon the system design, and does not limited to four. The pixel 1084 may be the pixel circuit 130 of Figure 14 or the pixel circuit 150 of Figure 15. The pixel array of Figure 19 is an active matrix light emitting display, and may be an AMOLED display.

In the display system of Figure 19, VDATA is used as a data line for the lth column and an output line for monitoring the pixel aging.

A gate driver 1066 drives SEL(k). The gate driver 1086 includes an address driver for providing address signals to SEL(k). A data driver 1088 generates a programming data and drives VDATA(l). The data driver 1088 includes a monitor 1090 for driving and monitoring the voltage of VDATA(l). Extractor block 1094 calculates the aging of the pixel based on the voltage generated on VDATA(l). VDATA(l) is appropriately activated for the operations of Figure 16A and 16B. VDATA(l) is calibrated using the monitoring result (i.e., the change of VDATA(l)). The monitoring result may be provided to a controller 1092. The data driver 1088, the controller 1092, the extractor 1094, or a combination thereof may include a memory for storing the monitoring result. The controller 1092 controls the drivers 1086 and 1088 and the extractor 1094 to drive the pixels 1084 as described above.

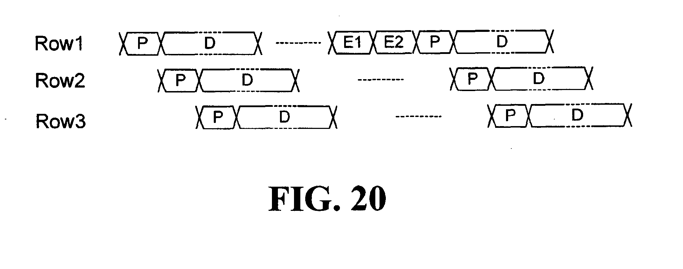

Figure 20 illustrates an example of the normal and extraction cycles for driving the pixel array of Figure 19. In Figure 20, each of ROWi (i=1, 2, ..) represents the ith row; "P" represents a programming cycle and corresponds to 180 of Figure 16B; "D" represents a driving cycle and corresponds to 182 of Figure 16B; "E1" represents the first extraction cycle and corresponds to 170 of Figure 16A; and "E2" represents a second extraction cycle and corresponds to 172 of Figure 16A. The extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality.

Figure 21 illustrates an example of a 3T pixel circuit to which a pixel operation scheme in accordance with a further embodiment of the present invention is suitably applied. The pixel circuit 190 of Figure 21 includes an OLED 172, a storage capacitor 194, a switch transistor 196, and a drive transistor 198. The pixel circuit 190 forms an AMOLED display.

The drain terminal of the drive transistor 198 is connected to the OLED 192, and the source terminal of the drive transistor 198 is connected to a power supply line VSS (e.g., ground). One terminal of the switch transistor 196 is connected to a data line VDATA, and the other terminal of the switch transistor 196 is connected to the gate terminal of the drive transistor 198. The gate terminal of the switch transistor 196 is connected to a select line SEL. One terminal of the storage capacitor 194 is connected to the gate terminal of the drive transistor 198, and the other terminal of the storage capacitor 194 is connected to VSS.

A sensing transistor 200 is provided to the pixel circuit 190. The transistor 200 may be included in the pixel circuit 190. The transistor 200 is connected between the drain terminal of the drive transistor 198 and an output line VOUT. The gate terminal of the transistor 200 is connected to the select line SEL.

The aging of the pixel circuit 190 is extracted by monitoring the voltage of the output line VOUT. SEL is shared by the switch transistor 196 and the transistor 200.

Figure 22 illustrates another example of a 3-transistor (3T) pixel circuit to which the pixel operation technique associated with Figure 21 is suitably applied. The pixel circuit 210 of Figure 22 includes an OLED 212, a storage capacitor 214, a switch transistor 216, and a drive transistor 218. The OLED 212 corresponds to the OLED 192 of Figure 21. The storage capacitor 214 corresponds to the storage capacitor 194 of Figure 21. The transistors 216 and 218 correspond to the transistors 196 and 198 of Figure 21. The pixel circuit 210 forms an AMOLED display.

The drain terminal of the drive transistor 218 is connected to a power supply line VDD, and the source terminal of the drive transistor 218 is connected to the OLED 212. The switch transistor 216 is connected between a data line VDATA and the gate terminal of the drive transistor 218. One terminal of the storage capacitor 214 is connected to the gate terminal of the drive transistor 218, and the other terminal of the storage capacitor 214 is connected to the source terminal of the drive transistor 218 and the OLED 212.

A sensing transistor 220 is provided to the pixel circuit 210. The transistor 220 may be included in the pixel circuit 210. The transistor 220 connects the source terminal of the drive transistor 218 and the OLED 212 to an output line VOUT. The transistor 220 corresponds to the transistor 200 of Figure 21. The gate terminal of the transistor 220 is connected to the select line SEL.

The aging of the pixel circuit 210 is extracted by monitoring the voltage of the output line VOUT. SEL is shared by the switch transistor 216 and the transistor 220.

Figure 23A illustrates an example of signal waveforms applied to the pixel circuits of Figures 21 and 22 during an extraction operation. Figure 23B illustrates an example of signal waveforms applied to the pixel circuits of Figures 21 and 22 during a normal operation.

Referring to 21, 22 and Figures 23A, the extraction operation includes an extraction cycle 170. During the extraction cycle 170, the gate terminal of the drive transistor (198 of Figure 21 or 218 of Figure 22) is charged to a calibration voltage V_{CG}. This calibration voltage V_{CG} includes the aging prediction, calculated based on the previous aging data. During the extraction cycle 230, the drive transistor (198 of Figure 21 or 218 of Figure 22) acts as an amplifier since it is biased with a constant current through VOUT. The voltage developed on VOUT as a result of current Ic applied to it is (V_{CD}+ΔV_{CD}). Therefore, the aging of the pixel is amplified, and change the voltage of the VOUT. Therefore, this method enables extraction of very small amount of voltage threshold (VT) shift resulting in highly accurate calibration. The change in VOUT is monitored. Then, the change(s) in VOUT is used for calibration of programming data

Also, applying a current/voltage to the OLED during extraction cycle, the system can extract the voltage/current of the OLED and determines the aging factor of the OLED and use it for more accurate calibration of the luminance data.

Referring to 21, 22 and 23B, the normal operation includes a programming cycle 240 and a driving cycle 242. During the programming cycle 240, the gate terminal of the drive transistor (198 of Figure 21 or 218 of Figure 22) is charged to a calibrated programming voltage V_{CP} using the monitoring result (i.e., the changes of VOUT). During the driving cycle 242, the select line SEL is low and the drive transistor (198 of Figure 21 or 218 of Figure 22) provides current to the OLED (192 of Figure 21 or 212 of Figure 22).

Figure 24 illustrates an example of a display system having the pixel circuit of Figure 21 or 22 where VOUT is separated from VDATA. The display system 1100 of Figure 24 includes a pixel array having a plurality of pixels 1104 arranged in row and column. In Figure 24, four pixels 1104 are shown. However, the number of the pixels 1104 may vary in dependence upon the system design, and does not limited to four. The pixel 1104 may be the pixel circuit 190 of Figure 21 or the pixel circuit 210 of Figure 22. The pixel array of Figure 24 is an active matrix light emitting display, and may be an AMOLED display.

SEL(k) (k=i, i+1) is a select line for selecting the kth row, and corresponds to SEL of Figures 21 and 22. VOUT(l) (l=j, j+1) is an output line for the lth column, and corresponds to VOUT of Figures 21 and 22. VDATA(l) is a data line for the lth column, and corresponds to VDATA of Figures 21 and 22.

A gate driver 1106 drives SEL(k). The gate driver 1106 includes an address driver for providing address signals to SEL(k). A data driver 1108 generates a programming data and drives VDATA(l). The data driver 1108 includes a monitor 1110 for driving and monitoring the voltage of VOUT(l). Extractor block 1114 calculates the aging of the pixel based on the voltage generated on VOUT(l). VDATA(l) and VOUT (l) are appropriately activated for the operations of Figure 23A and 23B. VDATA(l) is calibrated using the monitoring result (i.e., the change of VOUT(l)). The monitoring result may be provided to a controller 1112. The data driver 1108, the controller 1112, the extractor 1114, or a combination thereof may include a memory for storing the monitoring result. The controller 1112 controls the drivers 1106 and 1108 and the extractor 1114 to drive the pixels 1104 as described above.

Figures 25A and 25B illustrate two examples of the normal and extraction cycles for driving the pixel array of Figure 24. In Figure 25A and 25B, each of ROWi (i=1, 2, ..) represents the ith row; "P" represents a programming cycle and corresponds to 240 of Figure 23B; "D" represents a driving cycle and corresponds to 242 of Figure 23B; "E1" represents the first extraction cycle and corresponds to 230 of Figure 23A. In Figure 25A, the extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality. In Figure 25B, the extraction and programming happens in parallel.

Figure 26 illustrates an example of a 3T pixel circuit to which a pixel operation technique is suitably applied. The pixel circuit 260 of Figure 26 includes an OLED 262, a storage capacitor 264, a switch transistor 266, and a drive transistor 268. The pixel circuit 260 forms an AMOLED display.

The OLED 262 corresponds to the OLED 192 of Figure 21. The capacitor 264 corresponds to the capacitor 194 of Figure 21. The transistors 264 and 268 correspond to the transistors 196 and 198 of Figure 21, respectively. The gate terminal of the switch transistor 266 is connected to a first select line SEL1.

A sensing transistor 270 is provided to the pixel circuit 260. The transistor 270 may be included in the pixel circuit 260. The transistor 270 is connected between the drain terminal of the drive transistor 268 and VDATA. The gate terminal of the transistor 270 is connected to a second select line SEL2.

The aging of the pixel circuit 260 is extracted by monitoring the voltage of VDADA. VDATA is shared for programming and extracting the pixel aging.

Figure 27 illustrates another example of a 3T pixel circuit to which the pixel operation technique associated with Figure 26 is suitably applied. The pixel circuit 280 of Figure 27 includes an OLED 282, a storage capacitor 284, a switch transistor 286, and a drive transistor 288. The pixel circuit 280 forms an AMOLED display.

The OLED 282 corresponds to the OLED 212 of Figure 22. The capacitor 284 corresponds to the capacitor 214 of Figure 22. The transistors 284 and 288 correspond to the transistors 216 and 218 of Figure 22, respectively. The gate terminal of the switch transistor 286 is connected to a first select line SEL1.

A sensing transistor 290 is provided to the pixel circuit 280. The transistor 290 may be included in the pixel circuit 280. The transistor 290 is connected between the source terminal of the drive transistor 288 and VDATA. The transistor 290 corresponds to the transistor 270 of Figure 26. The gate terminal of the transistor 290 is connected to a second select line SEL2.

The aging of the pixel circuit 280 is extracted by monitoring the voltage of VDADA. VDATA is shared for programming and extracting the pixel aging.

Figure 28A illustrates an example of signal waveforms applied to the pixel circuits of Figures 26 and 27 during an extraction operation. Figure 28B illustrates an example of signal waveforms applied to the pixel circuits of Figures 26 and 27 during a normal operation.

Referring to 26, 27 and Figures 28A, the extraction operation includes first and second extraction cycles 300 and 302. During the first extraction cycle 300, the gate terminal of the drive transistor (268 of Figure 26 or 288 of Figure 27) is charged to a calibration voltage V_{CG}. This calibration voltage V_{CG} includes the aging prediction, calculated based on the previous aging data. During the second extraction cycle 302, the drive transistor (268 of Figure 26 or 288 of Figure 27) acts as an amplifier since it is biased with a constant current through VDATA. Therefore, the aging of the pixel is amplified, and the voltage of the VDATA changes accordingly. Therefore, this method enables extraction of very small amount of voltage threshold (VT) shift resulting in highly accurate calibration. The change in VDATA is monitored. Then, the change(s) in VDATA is used for calibration of programming data

Also, applying a current/voltage to the OLED during extraction cycle, the system can extract the voltage/current of the OLED and determines the aging factor of the OLED and use it for more accurate calibration of the luminance data.

Referring to 26, 27 and 28B, the normal operation includes a programming cycle 310 and a driving cycle 312. During the programming cycle 310, the gate terminal of the drive transistor (268 of Figure 26 or 288 of Figure 27) is charged to a calibrated programming voltage V_{CP} using the monitoring result (i.e., the changes of VDATA). Next, during the driving cycle 312, the select line SEL1 is low and the drive transistor (268 of Figure 26 or 288 of Figure 27) provides current to the OLED (262 of Figure 26. or 282 of Figure 27).

Figure 29 illustrates an example of a display system having the pixel circuit of Figure 26 or 27. The display system 1120 of Figure 29 includes a pixel array having a plurality of pixels 1124 arranged in row and column. In Figure 29, four pixels 1124 are shown. However, the number of the pixels 1124 may vary in dependence upon the system design, and does not limited to four. The pixel 1024 may be the pixel circuit 260 of Figure 26 or the pixel circuit 280 of Figure 27. The pixel array of Figure 29 is an active matrix light emitting display, and may be an AMOLED display.

SEL1(k) (k=i, i+1) is a first select line for selecting the kth row, and corresponds to SEL1 of Figures 26 and 27. SEL2(k) (k=i, i+1) is a second select line for selecting the kth row, and corresponds to SEL2 of Figures 26 and 27. VDATA(l) (l=j, j+1) is a data line for the lth column, and corresponds to VDATA of Figures 26 and 27.

A gate driver 1126 drives SEL1(k) and SEL2(k). The gate driver 1126 includes an address driver for providing address signals to SEL1 (k) and SEL2(k). A data driver 1128 generates a programming data and drives VDATA(l). The data driver 1128 includes a monitor 1130 for driving and monitoring the voltage of VDATA(l). Extractor block 1134 calculates the aging of the pixel based on the voltage generated on VDATA(i). VDATA(l) is appropriately activated for the operations of Figure 28A and 28B. VDATA(l) is calibrated using the monitoring result (i.e., the change of VDATA(l)). The monitoring result may be provided to a controller 1132. The data driver 1128, the controller 1132 , the extractor 1134 or a combination thereof may include a memory for storing the monitoring result. The controller 1132 controls the drivers 1126 and 1128 and the extractor 1134 to drive the pixels 1124 as described above.

Figure 30 illustrates an example of normal and extraction cycles for driving the pixel array of Figure 29. In Figure 30, each of ROWi (i=l, 2,..) represents the ith row; "P" represents a programming cycle and corresponds to 310 of Figure 28B; "D" represents a driving cycle and corresponds to 312 of Figure 28B; "E1" represents the first extraction cycle and corresponds to 300 of Figure 28A; "E2" represents the second extraction cycle and corresponds to 302 of Figure 28A. the extraction can happen at the end of each frame during the blanking time. During this time, the aging of several pixels can be extracted. Also, an extra frame can be inserted between several frames in which all pixels are OFF. During this frame, one can extract the aging of several pixels without affecting the image quality.

According to the examples of the display system illustrated in Figures 1 to 28B, pixel aging is extracted, and the pixel programming or biasing data is calibrated, which provides a highly accurate operation. According to the embodiments of the present invention, the programming/biasing of a flat panel becomes highly accurate resulting in less error. Thus it facilitates the realization of high-resolution large-are flat panels for displays and sensors.

Programming and reading out technique using shared data lines and select lines is further described in detail using Figure 31A to 35.

Figures 31A and 31B illustrate pixel circuits with readout capabilities at the jth row and the ith column. The pixel of Figure 31A includes a driver circuit 352 for driving a light emitting device (e.g., OLED), and a sensing circuit 356 for monitoring an acquisition data from the pixel. A transistor 354 is provided to connect a data line DATA[i] to the driver circuit 352 based on a signal on a select line SEL[j]. A transistor 358 is provided to connect the output from the monitoring circuit 356 to a readout line Readout[i]. In Figure 31A, the pixel is programmed through the data line DATA[i] via the transistor 354, and the acquisition data is read back through the readout line Readout[i] via the transistor 358.

The sensing circuit 356 may be a sensor, TFT, or OLED itself. The system of Figure 31A uses an extra line (i.e., Readout [i]).

In the pixel of Figure 31B the transistor 358 is connected to the data line DATA[i] or an adjacent data line, e.g., DATA[i-1], DATA[i+1]. The transistor 354 is selected by a first select line SEL1[i] while the transistor 358 is selected by an extra select line SEL2[i]. In Figure 31B, the pixel is programmed through the data line DATA[i] via the transistor 354. and the acquisition data is read back through the same data line or a data line for an adjacent row via the transistor 358. Although, the number of rows in a panel is generally less than the number of columns, the system of Figure 31B uses the extra select lines.

Figure 32 illustrates an example of a pixel circuit to which a pixel operation technique is suitably applied. The pixel circuit 370 of Figure 32 is at the jth row and ith column. In Figure 32, the data and readout line are merged without adding extra select line. The pixel circuit 370 of Figure 32 includes a driver circuit 372 for driving a light emitting device (e.g. OLED), and a sensing circuit 376 for sensing an acquisition data from the pixel. A transistor 374 is provided to connect a data line DATA[i] to the driver circuit 372 based on a signal on a select line SEL[i]. The pixel is programmed while SEL[j] is high. A sensing network 378 is provided to the sensing circuit 376.

The sensing circuit 376 senses the pixel electrical, optical, or temperature signals of the driver circuit 352. Thus, the output of the sensing circuit 376 determines the pixel aging overtime. The monitor circuit 376 may be a sensor, a TFT, a TFT of the pixel, or OLED of the pixel (e.g., 14 of Figure 1).

In one example, the sensing circuit 376 is connected, via the sensing network 378, to the data line DATA[i] of the column in which the pixel is. In another example, the sensing circuit 376 is connected, via the sensing network 378, a data line for one of the adjacent columns e.g., DATA [i+1], or DATA[i-1].

The sensing network 378 includes transistors 380 and 382. The transistors 380 and 382 are connected in series between the output of the monitor circuit 376 and a data line, e.g., DATA[i]. DATA[i-1], DATA[i+1]. The transistor 380 is selected by a select line for an adjacent row, e.g., SEL[i-1], SEL[i+1]. The transistor 382 is selected by the select line SEL[i], which is also connected to the gate terminal of the transistor 374.

The driver circuit 372, the monitor circuit 376, and the switches 374, 380 and 382 may be fabricated in amorphous silicon, poly silicon, organic semiconductor, or CMOS technologies.

The arrangement of Figure 32 can be used with different timing schedule. However, one of them is shown in Figure 33. The operation cycles of Figure 33 includes a programming cycle 380, a driving cycle 392, and a readback cycle 394.

Referring to Figures 32 and 33, during the programming cycle 390, the pixel is programmed through DATA[i] while SEL[i] is ON During the driving cycle 392. SEL[i] goes OFF. For the readout process 394, SEL[i] and one adjacent row's select line SEL[i-1] or SEL[j+1] are ON, and so the monitoring data is read back through DATA[i]. DATA[i-1] or DATA[i+1] which is connected to the sensing network 378.

The transistors 3 80 and 3 82 can be easily swapped without affecting the readout process.

Figure 34 illustrates another example of a pixel circuit to which the pixel operation technique associated with Figure 32 is suitably applied. The pixel circuit 400 of Figure 34 is at the jth row and ith column. In Figure 34, the data and readout line are merged without adding extra select line. The pixel circuit 400 of Figure 34 includes an OLED (now shown), the driver circuit 372, and the sensing circuit 376. A sensing network 408 is provided to the sensing circuit 376. The sensing network 408 includes transistors 410 and 412. The transistor 410 and 412 are same or similar to the transistors 380 and 382 of Figure 32, respectively. The gate terminal of the transistor 410 is connected to a select line SEL[j-1] for the (j-1)th row. The gate terminal of the transistor 412 is connected to a select line SEL[j+1] for the (j+1)th row. The pixel is programmed while SEL[i] is high. The transistor 412 may be shared by more than one pixel.

In one example, the monitoring circuit 376 is connected, via the sensing network 408, to the data line DATA[j] of the column in which the pixel is. In another example, the monitoring circuit 376 is connected, via the sensing network 408, a data line for one of the adjacent columns e.g., DATA [i+1], DATA[i-1].

The switches 410 and 412 can be fabricated in amorphous silicon, poly silicon, organic semiconductor, or CMOS technologies.

The arrangement of Figure 34 can be used with different timing schedule. However, one of them is shown in Figure 35. The operation cycles of Figure 35 includes a programming cycle 420, a driving cycle 422, and a readback cycle 424.

Referring to Figures 34 and 35, during the programming cycle 420, the pixel is programmed through DATA[i] while SEL[j] is ON During the driving cycle 422, SEL[j] goes Off. For the readout process 424, SEL[j-1] and are ON. and so the monitoring data is read back through DATA[i], DATA[i-1] or DATA[i+1] which is connected to the sensing network 408. The transistors 410 and 412 can be easily exchanged without affecting the readout process.

The display systems having the pixel structures of Figures 31 and 34 are similar to those of the display system described above. Data read back from the sensing network is used to calibrate programming data.

The technique according to the examples illustrated in Figures 32 to 40 shares the data line used to program the pixel circuit and the readout line used to extract the pixel aging data without affecting the pixie circuit operation and without adding extra controlling signal. The number of signals connected to the panel is reduced significantly. Thus the complexity of the driver is reduced. It reduces the implementation cost of the external driver decreases and reduces the cost of calibration tourniquets in active matrix light emitting displays, in particular AMOLED displays.

A technique for increasing the aperture ratio pixel circuits of the calibration techniques is described in detail using Figures 36 to 38.

Figure 36 illustrates a further example of a pixel array. The pixel array 500 of Figure 36 includes a plurality of pixel circuits 510 arranged in rows and columns. In Figure 36, two pixels 510 in the jth column are shown. The pixel circuit 510 includes an OLED 512, a storage capacitor 514, a switch transistor 516, and a drive transistor 518. The OLED 512 corresponds to the OLED 212 of Figure 22. The storage capacitor 514 corresponds to the storage capacitor 214 of Figure 22. The transistors 516 and 518 correspond to the transistors 216 and 218 of Figure 22.

The drain terminal of the drive transistor 518 is connected to a power supply line VDD, and the source terminal of the drive transistor 518 is connected to the OLED 512. The switch transistor 516 is connected between a corresponding data line Data [j] and the gate terminal of the drive transistor 518. One terminal of the storage capacitor 514 is connected to the gate terminal of the drive transistor 518, and the other terminal of the storage capacitor 514 is connected to the source terminal of the drive transistor 518 and the OLED 512.

A sensing network 550 is provided to the pixel array 500. The network 550 includes a sensing transistor 532 for each pixel and a sensing transistor 534. The transistor 532 may be included in the pixel 500. The sensing transistor 534 is connected to a plurality of switch transistors 532 for a plurality of pixels 510. In Figure 36, the sensing transistor 534 is connected to two switch transistors 532 for two pixels 510 in the jth column.

The transistor 532 for the pixel 510 at position (i, j) is connected to a data line DATA [j+1] via the transistor 534, and is also connected to the OLED 512 in the pixel 510 at position (i, j). Similarly, the transistor 532 for the pixel 510 at position (i-h, j) is connected to the data line DATA [j+1] via the transistor 534, and is also connected to the OLED 512 in the pixel 510 at position (i-h, j). DATA [j+1] is a data line for programming the (j+1) th column.

The transistor 532 for the pixel 510 at position (i, j) is selected by a select line SEL[k] for the "k"th row. The transistor 532 for the pixel 510 at position (i-h, j) is selected by a select line SEL[k'] for the k' th row. The sensing transistor 534 is selected by a select line SEL[t] for the "t"th row. There can be no relation among "i", "i-h", "k", "k"', and "t". However, to have a compact pixel circuit for a higher resolution, it is better that they be consecutive. The two transistors 532 are connected to the transistor 534 through an internal line, i.e., monitor line [j, j+1].

The pixels 510 in one column are divided into few segments (each segments has 'h' number of pixels). In the pixel array 500 of 36, the two pixels in one column are in one segment. A calibration component (e.g., transistor 534) is shared by the two pixels.

In Figure 36, the pixel at the jth column is programmed through the data line, DATA[j], and the acquisition data is read back through the data line for an adjacent column, e.g., DATA [j+1] (or DATA [j-1]). Since SEL(i) is OFF during programming and during extraction, the switch transistor 516 is OFF. The sensing switch 534 grantees a conflict free readout and programming procedures.

Figure 37 illustrates RGBW structure using the pixel array 500 of Figure 36. In Figure 37, two pixels form one segment. In Figure 37. "CSR". "T1R", "T2R", and "T3R" are components for a pixel for red "R", and correspond to 514, 518, 516, and 532 of Figure 36; "CSG", "T1G", "T2G", and "T3G" are components for a pixel for green "G", and correspond to 514, 518, 516, and 532 of Figure 36; "CSB", "T1B", "T2B", and "T3B" are components for a pixel for blue "B", and correspond to 514, 518, 516, and 532 of Figure 36; "CSW", "T1W", "T2W", and "T3W" are components for a pixel for white "W", and correspond to 514, 518, 516, and 532 of Figure 36.

In Figure 37, "TWB" represents a sensing transistor shared by two pixels for "W" and "B", and corresponds to the sensing transistor 534 of Figure 36; and "TGR" represents a sensing transistor shared by two pixels for "G" and "R", and corresponds to the sensing transistor 534 of Figure 36.

The gate terminals of the transistors T3W and T3G are connected to a select line SEL[i] for the ith row. The gate terminals of the transistors T3B and T3R are connected to a select line SEL[i+1] for the ith row. The gate terminal of the sensing transistor TWB and the gate terminal of the sensing transistor TGR are connected to the select line SEL[i] for the ith row.

The sensing transistors TWB and TGR of the two adjacent segments which use the SEL[i] for sensing is put in the segment area of pixels which use SEL [i] for programming to reduce the layout complexity where one segment includes two pixel which shares the same sensing transistor.

Figure 38 illustrates a layout for the pixel circuits of Figure 37. In Figure 45, "R" is an area associated with a pixel for read; "G" is an area associated with a pixel for green; "B" is an area associated with a pixel for blue; "W" is an area associated with a pixel for white. "TWB" corresponds to the sensing transistor TWB of Figure 37, and shared by the pixel for while and the pixel for while. "TGR" corresponds to the sensing transistors TGR of Figure 37, and is shared by the pixel for green and the pixel for red. The size of the pixel is, for example, 208um x 208 um. It shows the applicability of the circuit to a very small pixel for high resolution displays

## Claims

1. A display system, comprising:
multiple pixels (1004) arranged in a matrix of rows (n) and columns (m), each of said pixels (1004) having a light emitting device (72, 92), wherein the light emitting device (72, 92) is an organic light emitting diode, a drive transistor (78, 98) for driving the light emitting device (72, 92), and a switch transistor (76, 96) for selecting the pixel (1004);
a power supply line (VSS, VDD) for each of said multiple rows (n) of pixels (1004) and coupled to said drive transistor (78, 98) in each of said pixels (1004);
multiple first select lines (SEL1) for selecting said rows (n) of said pixels (1004) in said matrix, each row being coupled to a respective one of said multiple first select lines (SEL1):
multiple data lines (VDATA) for supplying calibration voltages (VCG) and programming data to said columns (m) of pixels (1004) in said matrix, each column being coupled to a respective one of said multiple data lines (VDATA)*;*
a driver for supplying current to a selected pixel (1004) of a i-th row to produce a voltage that corresponds to a characteristic of said selected pixel (1004) that varies with the age of that pixel (1004);
wherein the driver is adapted to, during a first extraction cycle, charge a gate terminal of the drive transistor (78, 98) in the selected pixel (1004) to a calibration voltage (VCG), and
wherein during a second extraction cycle following the first extraction cycle, the driver is adapted to bring the voltage of the first select line (SEL1) of the selected pixel (1004) to zero while the drive transistor (78, 98) in said selected pixel (1004) is biased with a constant current through a monitoring line (VOUT) for the selected pixel (1004) so that said drive transistor (78, 98) in said selected pixel (1004) acts as an amplifier that amplifies any shift in said characteristic so as to produce said voltage that corresponds to the characteristic of said selected pixel; and
circuitry for detecting said amplified voltage and using the detected amplified voltage to determine an adjustment of the calibration voltage (VCG) for said selected pixel (1004);
wherein said circuitry includes a sensing network comprising a sensing transistor (80, 100) that connects the monitoring line (VOUT) to a path between the light emitting device (72) and the drive transistor (78), a gate terminal of the sensing transistor (80, 100) being connected to a second select line (SEL2), wherein the aging of the selected pixel is extracted during said second extraction cycle using said select line (SEL2) and by monitoring the voltage of the monitoring line (VOUT).

2. A display system according to claim 1, wherein the monitoring line is a data line (VDATA) for providing display data to a physically adjacent column.

3. A display system, comprising:
multiple pixels (1064) arranged in a matrix of rows (n) and columns (m), each of said pixels (1064) having a light emitting device (192, 212), wherein the light emitting device (192, 212) is an organic light emitting diode, a drive transistor (138, 158) for driving the light emitting device (192, 212), and a switch transistor (136, 156) for selecting the pixel (1064);
a power supply line (VSS, VDD) for each of said multiple rows (n) of pixels (1064) and coupled to said drive transistor (138, 158) in each of said pixels (1064);
multiple select lines (SEL[j]) for selecting said rows (n) of said pixels (1064) in said matrix, each row being coupled to a respective one of said multiple select lines (SEL[j]);
multiple data lines (VDATA) for supplying calibration voltages (VCG) and programming data to said columns (m) of pixels (1064) in said matrix, each column being coupled to a respective one of said multiple data lines (VDATA);
a driver for supplying current to a selected pixel (1064) of a i-th row to produce a voltage that corresponds to a characteristic of said selected pixel (1064) that varies with the age of that pixel (1064);
wherein the driver is adapted to, during a first extraction cycle, charge a gate terminal of the drive transistor (138, 158) in the selected pixel (1064) to a calibration voltage (VCG), and
wherein during a second extraction cycle following the first extraction cycle, the driver is adapted to bring the voltage of the select line (SEL[j]) of the selected pixel (1064) to zero while the drive transistor (138, 158) in said selected pixel (1064) is biased with a constant current through a monitoring line (VOUT) for the selected pixel (1064) so that said drive transistor (138, 158) in said selected pixel (1064) acts as an amplifier that amplifies any shift in said characteristic so as to produce said voltage that corresponds to the characteristic of said selected pixel; and
circuitry for detecting said amplified voltage and using the detected amplified voltage to determine an adjustment of the calibration voltage (VCG) for said selected pixel (1064);
wherein said circuitry includes a sensing network for connecting the monitoring line (VOUT) to a path between the light emitting device (132, 152) and the drive transistor (138, 158), the sensing network comprising a first sensing transistor (142, 162), and a second sensing transistor (144, 164) connected in series between said path and the monitoring line (VOUT), the gate terminal of the first sensing transistor (142) being connected to the select line (SEL[i+1]) used for selecting the row that follows the row of the selected pixel and the gate terminal of the second sensing transistor (142) being connected to the select line (SEL[i-1]) used for selecting the row that precedes the row of the selected pixel, wherein the aging of the selected pixel (1064) is extracted during the second extraction cycle using said select lines and by monitoring the voltage of the monitoring line (VOUT).

4. A display system, comprising:
multiple pixels (1104) arranged in a matrix of rows (n) and columns (m), each of said pixels (1104) having a light emitting device (192, 212), wherein the light emitting device (192, 212) is an organic light emitting diode, a drive transistor (198, 218) for driving the light emitting device (192, 212), and a switch transistor (196, 216) for selecting the pixel (1104);
a power supply line (VSS, VDD) for each of said multiple rows (n) of pixels (1104) and coupled to said drive transistor (198, 218) in each of said pixels (1104);
multiple select lines (SEL) for selecting said rows (n) of said pixels (1104) in said matrix, each row being coupled to a respective one of said multiple select lines (SEL);
multiple data lines (VDATA) for supplying calibration voltages (VCG) and programming data to said columns (m) of pixels (1104) in said matrix, each column being coupled to a respective one of said multiple data lines (VDATA);
a driver for supplying current to a selected pixel (1104) of a i-th row to produce a voltage that corresponds to a characteristic of said selected pixel (1104) that varies with the age of that pixel (1104);
wherein the driver is adapted to, during an extraction cycle, charge a gate terminal of the drive transistor (198, 218) in the selected pixel (1104) to a calibration voltage (VCG), and to maintain the voltage of the select line (SEL) of the selected pixel (1104) so that the drive transistor (198, 218) in said selected pixel (1104) is biased with a constant current through a monitoring line (VOUT) for the selected pixel (1104) so that said drive transistor (198, 218) in said selected pixel (1104) acts as an amplifier that amplifies any shift in said characteristic to as to produce said voltage that corresponds to the characteristic of said selected pixel; and
circuitry for detecting said amplified voltage and using the detected amplified voltage to determine an adjustment of the calibration voltage (VCG) for said selected pixel (1104);
wherein each pixel comprises a sensing circuit (198, 356, 376) for monitoring the pixel aging, and said circuitry includes a sensing network for connecting the sensing circuit (198, 356, 376) to the monitoring line (VOUT), the sensing network comprising a first sensing transistor (200, 358, 380) that connects the monitoring line (VOUT) to the sensing circuit (198, 356, 376) and having a gate terminal that is connected to the select line (SEL), wherein the aging of the selected pixel is extracted using said select line and by monitoring the voltage of the monitoring line.

5. A display system according to one of claims 1 to 4, wherein said pixels form a RGBW pixel array.

6. A display system according to claim 3, wherein the data line (VDATA) for each column is used as monitoring line (VOUT).

7. A display system according to any one of claims 1 to 6, wherein at least a part of the system is fabricated using at least one material selected from the group consisting of amorphous silicon, poly silicon, and nano/micro crystalline silicon, and using at least one technology selected from the group consisting of organic semiconductors technology, TFT, NMOS/PMOS technology, CMOS technology, and MOSFET technology.

## Patentansprüche

1. Anzeigesystem, das umfasst:
mehrere Pixel (1004), die in einer Matrix aus Reihen (n) und Spalten (m) angeordnet sind, wobei jedes der Pixel (1004) eine lichtemittierende Einrichtung (72, 92) aufweist und die lichtemittierende Einrichtung (72, 92) eine organische Leuchtdiode ist, und es einen Ansteuer-Transistor (78, 98) zum Ansteuern der lichtemittierenden Einrichtung (72, 92) sowie einen Schalt-Transistor (76, 96) zum Auswählen des Pixels (1004) aufweist;
eine Stromversorgungs-Leitung (VSS, VDD) für jede der mehreren Reihen (n) von Pixeln (1004), die mit dem Ansteuer-Transistor (78, 98) in jedem der Pixel (1004) gekoppelt ist;
mehrere erste Auswähl-Leitungen (SEL1) zum Auswählen der Reihen (n) der Pixel (1004) in der Matrix, wobei jede Reihe mit einer entsprechenden der mehreren ersten Auswähl-Leitungen (SEL1) gekoppelt ist;
mehrere Daten-Leitungen (VDATA) zum Zuführen von Kalibrierungs-Spannungen (VCG) und Programmierungs-Daten zu den Spalten (m) von Pixeln (1004) in der Matrix, wobei jede Spalte mit einer entsprechenden der mehreren Daten-Leitungen (VDATA) gekoppelt ist;
eine Ansteuereinrichtung, mit der einem ausgewählten Pixel (1004) einer i-ten Reihe Strom zugeführt wird, um eine Spannung zu erzeugen, die einer Kennlinie des ausgewählten Pixels (1004) entspricht, die mit dem Alter dieses Pixels (1004) variiert;
wobei die Ansteuereinrichtung so eingerichtet ist, dass sie während eines ersten Extraktions-Zyklus einen Gate-Anschluss des Ansteuer-Transistors (78, 98) in dem ausgewählten Pixel (1004) auf eine Kalibrierungsspannung (VCG) lädt, und
die Ansteuereinrichtung so eingerichtet ist, dass sie während eines zweiten Extraktions-Zyklus, der auf den ersten Extraktions-Zyklus folgt, die Spannung der ersten Auswähl-Leitung (SEL1) des ausgewählten Pixels (1004) auf Null bringt, während der Ansteuer-Transistor (78, 98) in dem ausgewählten Pixel (1004) über eine Überwachungs-Leitung (VOUT) für das ausgewählte Pixel (1004) mit einem konstanten Strom vorgespannt wird, so dass der Ansteuer-Transistor (78, 98) in dem ausgewählten Pixel (1004) als ein Verstärker wirkt, der jede Verschiebung in der Kennlinie verstärkt, um die Spannung zu erzeugen, die der Kennlinie des ausgewählten Pixels entspricht; und
eine Schaltung, mit der die verstärkte Spannung erfasst wird und die erfasste verstärkte Spannung genutzt wird, um eine Anpassung der Kalibrierungs-Spannung (VCG) für das ausgewählte Pixel (1004) zu bestimmen;
wobei die Schaltung ein Erfassungs-Netzwerk enthält, das einen Erfassungs-Transistor (80, 100) umfasst, der die Überwachungs-Leitung (VOUT) mit einem Pfad zwischen der lichtemittierenden Einrichtung (72) und dem Ansteuer-Transistor (78) verbindet, ein Gate-Anschluss des Erfassungs-Transistors (80, 100) mit einer zweiten Auswähl-Leitung (SEL2) verbunden ist und das Altern des ausgewählten Pixels während des zweiten Extraktions-Zyklus unter Verwendung der Auswähl-Leitung (SEL2) sowie durch Überwachen der Spannung der Überwachungs-Leitung (VOUT) extrahiert wird.

2. Anzeigesystem nach Anspruch 1, wobei die Überwachungs-Leitung eine Daten-Leitung (VDATA) ist, mit der einer physisch benachbarten Spalte Anzeige-Daten bereitgestellt werden.

3. Anzeigesystem, das umfasst:
mehrere Pixel (1064), die in einer Matrix aus Reihen (n) und Spalten (m) angeordnet sind, wobei jedes der Pixel (1064) eine lichtemittierende Einrichtung (192, 212) aufweist und die lichtemittierende Einrichtung (192, 212) eine organische Leuchtdiode ist, und es einen Ansteuer-Transistor (138, 158) zum Ansteuern der lichtemittierenden Einrichtung (192, 212) sowie einen Schalt-Transistor (136, 156) zum Auswählen des Pixels (1064) aufweist;
eine Stromversorgungs-Leitung (VSS, VDD) für jede der mehreren Reihen (n) von Pixeln (1064), die mit dem Ansteuer-Transistor (138, 158) in jedem der Pixel (1064) gekoppelt ist;
mehrere Auswähl-Leitungen (SEL[j]) zum Auswählen der Reihen (n) der Pixel (1064) in der Matrix, wobei jede Reihe mit einer entsprechenden der mehreren Auswähl-Leitungen (SEL[j]) gekoppelt ist;
mehrere Daten-Leitungen (VDATA) zum Zuführen von Kalibrierungs-Spannungen (VCG) und Programmierungs-Daten zu den Spalten (m) von Pixeln (1064) in der Matrix, wobei jede Spalte mit einer entsprechenden der mehreren Daten-Leitungen (VDATA) gekoppelt ist;
eine Ansteuereinrichtung, mit der einem ausgewählten Pixel (1064) einer i-ten Reihe Strom zugeführt wird, um eine Spannung zu erzeugen, die einer Kennlinie des ausgewählten Pixels (1064) entspricht, die mit dem Alter dieses Pixels (1064) variiert;
wobei die Ansteuereinrichtung so eingerichtet ist, dass sie während eines ersten Extraktions-Zyklus einen Gate-Anschluss des Ansteuer-Transistors (138, 158) in dem ausgewählten Pixel (1064) auf eine Kalibrierungsspannung (VCG) lädt, und
die Ansteuereinrichtung so eingerichtet ist, dass sie während eines zweiten Extraktions-Zyklus, der auf den ersten Extraktions-Zyklus folgt, die Spannung der Auswähl-Leitung (SEL[j]) des ausgewählten Pixels (1064) auf Null bringt, während der Ansteuer-Transistor (138, 158) in dem ausgewählten Pixel (1064) über eine Überwachungs-Leitung (VOUT) für das ausgewählte Pixel (1064) mit einem konstanten Strom vorgespannt wird, so dass der Ansteuer-Transistor (138, 158) in dem ausgewählten Pixel (1064) als ein Verstärker wirkt, der jede Verschiebung in der Kennlinie verstärkt, um die Spannung zu erzeugen, die der Kennlinie des ausgewählten Pixels entspricht; und
eine Schaltung, mit der die verstärkte Spannung erfasst wird und die erfasste verstärkte Spannung genutzt wird, um eine Anpassung der Kalibrierungs-Spannung (VCG) für das ausgewählte Pixel (1064) zu bestimmen;
wobei die Schaltung ein Erfassungs-Netzwerk zum Verbinden der Überwachungs-Leitung (VOUT) mit einem Pfad zwischen der lichtemittierenden Einrichtung (132, 152) und dem Ansteuer-Transistor (138, 158) enthält, das Erfassungs-Netzwerk einen ersten Erfassungs-Transistor (142, 162) sowie einen zweiten Erfassungs-Transistor (144, 164) umfasst, die in Reihe zwischen den Pfad und die Überwachungs-Leitung (VOUT) geschaltet sind, der Gate-Anschluss des ersten Erfassungs-Transistors (142) mit der Auswähl-Leitung (SEL[j+1]) verbunden ist, die zum Auswählen der auf die Reihe des ausgewählten Pixels folgenden Reihe dient, und der Gate-Anschluss des zweiten Erfassungs-Transistors (142) mit der Auswähl-Leitung (SEL[j-1]) verbunden ist, die zum Auswählen der der Reihe des ausgewählten Pixels vorangehenden Reihe dient, und wobei das Altern des ausgewählten Pixels (1064) während des zweiten Extraktions-Zyklus unter Verwendung der Auswähl-Leitungen sowie durch Überwachen der Spannung der Überwachungs-Leitung (VOUT) extrahiert wird.

4. Anzeigesystem, das umfasst:
mehrere Pixel (1104), die in einer Matrix aus Reihen (n) und Spalten (m) angeordnet sind, wobei jedes der Pixel (1104) eine lichtemittierende Einrichtung (192, 212) aufweist und die lichtemittierende Einrichtung (192, 212) eine organische Leuchtdiode ist, und es einen Ansteuer-Transistor (198, 218) zum Ansteuern der lichtemittierenden Einrichtung (192, 212) sowie einen Schalt-Transistor (196, 216) zum Auswählen des Pixels (1104) aufweist;
eine Stromversorgungs-Leitung (VSS, VDD) für jede der mehreren Reihen (n) von Pixeln (1104), die mit dem Ansteuer-Transistor (198, 218) in jedem der Pixel (1104) gekoppelt ist;
mehrere Auswähl-Leitungen (SEL) zum Auswählen der Reihen (n) der Pixel (1104) in der Matrix, wobei jede Reihe mit einer entsprechenden der mehreren ersten Auswähl-Leitungen (SEL) gekoppelt ist;
mehrere Daten-Leitungen (VDATA) zum Zuführen von Kalibrierungs-Spannungen (VCG) und Programmierungs-Daten zu den Spalten (m) von Pixeln (1104) in der Matrix, wobei jede Spalte mit einer entsprechenden der mehreren Daten-Leitungen (VDATA) gekoppelt ist;
eine Ansteuereinrichtung, mit der einem ausgewählten Pixel (1104) einer i-ten Reihe Strom zugeführt wird, um eine Spannung zu erzeugen, die einer Kennlinie des ausgewählten Pixels (1104) entspricht, die mit dem Alter dieses Pixels (1104) variiert;
wobei die Ansteuereinrichtung so eingerichtet ist, dass sie während eines Extraktions-Zyklus einen Gate-Anschluss des Ansteuer-Transistors (198, 218) in dem ausgewählten Pixel (1104) auf eine Kalibrierungsspannung (VCG) lädt und die Spannung der Auswähl-Leitung (SEL) des ausgewählten Pixels (1104) aufrechterhält, so dass der Ansteuer-Transistor (198, 218) in dem ausgewählten Pixel (1104) über eine Überwachungs-Leitung (VOUT) für das ausgewählte Pixel (1104) mit einem konstanten Strom vorgespannt wird,
so dass der Ansteuer-Transistor (198, 218) in dem ausgewählten Pixel (1104) als ein Verstärker wirkt, der jede Verschiebung der Kennlinie verstärkt, um die Spannung zu erzeugen, die der Kennlinie des ausgewählten Pixels entspricht; und
eine Schaltung, mit der die verstärkte Spannung erfasst wird und die verstärkte Spannung verwendet wird, um eine Anpassung der Kalibrierungs-Spannung (VCG) für das ausgewählte Pixel (1104) zu bestimmen;
wobei jedes Pixel eine Erfassungs-Schaltung (198, 356, 376) zum Überwachen des Alterns des Pixels umfasst und die Schaltung ein Erfassungs-Netzwerk zum Verbinden der Erfassungs-Schaltung (198, 356, 376) mit der Überwachungs-Leitung (VOUT) enthält, das Erfassungs-Netzwerk einen ersten Erfassungs-Transistor (200, 358, 380) umfasst, der die Überwachungs-Leitung (VOUT) mit der Erfassungs-Schaltung (198, 356, 376) verbindet und einen Gate-Anschluss hat, der mit der Auswähl-Leitung (SEL) verbunden ist, und das Altern des ausgewählten Pixels unter Verwendung der Auswähl-Leitung sowie durch Überwachen der Spannung der Überwachungs-Leitung extrahiert wird.

5. Anzeigesystem nach einem der Ansprüche 1 bis 4, wobei die Pixel ein RGBW-Pixel-Array bilden.

6. Anzeigesystem nach Anspruch 3, wobei die Daten-Leitung (VDATA) für jede Spalte als Überwachungs-Leitung (VOUT) dient.

7. Anzeigesystem nach einem der Ansprüche 1 bis 6, wobei wenigstens ein Teil des Systems unter Verwendung wenigstens eines Materials, das aus der Gruppe ausgewählt wird, die aus amorphem Silizium, Polysilizium sowie nano-/mikrokristallinem Silizium besteht, und unter Verwendung wenigstens einer Technologie hergestellt wird, die aus der Gruppe ausgewählt wird, die aus organischer Halbleitertechnologie, TFT, NMOS/PMOS-Technologie, CMOS-Technologie sowie MOSFET-Technologie besteht.

## Revendications

1. Système d'affichage, comprenant :
de multiples pixels (1004) agencés dans une matrice de rangées (n) et de colonnes (m), chacun desdits pixels (1004) comportant un dispositif électroluminescent (72, 92), dans lequel le dispositif électroluminescent (72, 92) est une diode électroluminescente organique, un transistor de commande (78, 98) pour commander le dispositif électroluminescent (72, 92), et un transistor de commutation (76, 96) pour sélectionner le pixel (1004) ;
une ligne d'alimentation de puissance (VSS, VDD) pour chacune desdites multiples rangées (n) de pixels (1004) et accouplée audit transistor de commande (78, 98) dans chacun desdits pixels (1004) ;
de multiples premières lignes de sélection (SEL1) pour sélectionner lesdites rangées (n) desdits pixels (1004) dans ladite matrice, chaque rangée étant accouplée à une ligne respective desdites multiples premières lignes de sélection (SEL1) ;
de multiples lignes de données (VDATA) pour fournir des tensions d'étalonnage (VCG) et des données de programmation auxdites colonnes (m) de pixels (1004) dans ladite matrice, chaque colonne étant accouplée à une ligne respective desdites multiples lignes de données (VDATA) ;
un pilote pour alimenter du courant à un pixel sélectionné (1004) d'une i^{ème} rangée pour produire une tension qui correspond à une caractéristique dudit pixel sélectionné (1004) qui varie avec l'âge de ce pixel (1004) ;
dans lequel le pilote est adapté pour, durant un premier cycle d'extraction, charger une borne de grille du transistor de commande (78, 98) dans le pixel sélectionné (1004) à une tension d'étalonnage (VCG) ; et
dans lequel, durant un deuxième cycle d'extraction qui suit le premier cycle d'extraction, le pilote est adapté pour amener la tension de la première ligne de sélection (SEL1) du pixel sélectionné (1004) à zéro alors que le transistor de commande (78, 98) dans ledit pixel sélectionné (1004) est polarisé par un courant constant passant par une ligne de surveillance (VOUT) pour le pixel sélectionné (1004) de telle sorte que ledit transistor de commande (78, 98) dans ledit pixel sélectionné (1004) agit comme un amplificateur qui amplifie tout changement de ladite caractéristique de manière à produire ladite tension qui correspond à la caractéristique dudit pixel sélectionné ; et
un circuit pour détecter ladite tension amplifiée et utiliser la tension amplifiée détectée pour déterminer un ajustement de la tension d'étalonnage (VCG) pour ledit pixel sélectionné (1004) ;
dans lequel ledit circuit comprend un réseau de détection comprenant un transistor de détection (80, 100) qui connecte la ligne de surveillance (VOUT) à un chemin entre le dispositif électroluminescent (72) et le transistor de commande (78), une borne de grille du transistor de détection (80, 100) étant connectée à une deuxième ligne de sélection (SEL2), dans lequel l'âge du pixel sélectionné est extrait durant ledit deuxième cycle d'extraction en utilisant ladite ligne de sélection (SEL2) et en surveillant la tension de la ligne de surveillance (VOUT).

2. Système d'affichage selon la revendication 1, dans lequel la ligne de surveillance est une ligne de données (VDATA) pour procurer des données d'affichage à une colonne physiquement adjacente.

3. Système d'affichage, comprenant :
de multiples pixels (1064) agencés dans une matrice de rangées (n) et de colonnes (m), chacun desdits pixels (1064) comportant un dispositif électroluminescent (192, 212), dans lequel le dispositif électroluminescent (192, 212) est une diode électroluminescente organique, un transistor de commande (138, 158) pour commander le dispositif électroluminescent (192, 212), et un transistor de commutation (136, 156) pour sélectionner le pixel (1064) ;
une ligne d'alimentation de puissance (VSS, VDD) pour chacune desdites multiples rangées (n) de pixels (1064) et accouplée audit transistor de commande (138, 158) dans chacun desdits pixels (1064) ;
de multiples lignes de sélection (SEL[j]) pour sélectionner lesdites rangées (n) desdits pixels (1064) dans ladite matrice, chaque rangée étant accouplée à une ligne respective desdites multiples lignes de sélection (SEL[j]) ;
de multiples lignes de données (VDATA) pour fournir des tensions d'étalonnage (VCG) et des données de programmation auxdites colonnes (m) de pixels (1064) dans ladite matrice, chaque colonne étant accouplée à une ligne respective desdites multiples lignes de données (VDATA) ;
un pilote pour alimenter du courant à un pixel sélectionné (1064) d'une i^{ème} rangée pour produire une tension qui correspond à une caractéristique dudit pixel sélectionné (1064) qui varie avec l'âge de ce pixel (1064) ;
dans lequel le pilote est adapté pour, durant un premier cycle d'extraction, charger une borne de grille du transistor de commande (138, 158) dans le pixel sélectionné (1064) à une tension d'étalonnage (VCG) ; et
dans lequel, durant un deuxième cycle d'extraction qui suit le premier cycle d'extraction, le pilote est adapté pour amener la tension de la ligne de sélection (SEL[j]) du pixel sélectionné (1064) à zéro alors que le transistor de commande (138, 158) dans ledit pixel sélectionné (1064) est polarisé par un courant constant passant par une ligne de surveillance (VOUT) pour le pixel sélectionné (1064) de telle sorte que ledit transistor de commande (138, 158) dans ledit pixel sélectionné (1064) agit comme un amplificateur qui amplifie toute déviation de ladite caractéristique de manière à produire ladite tension qui correspond à la caractéristique dudit pixel sélectionné ; et
un circuit pour détecter ladite tension amplifiée et utiliser la tension amplifiée détectée pour déterminer un ajustement de la tension d'étalonnage (VCG) pour ledit pixel sélectionné (1064) ;
dans lequel ledit circuit comprend un réseau de détection pour connecter la ligne de surveillance (VOUT) à un chemin entre le dispositif électroluminescent (132, 152) et le transistor de commande (138, 158), le réseau de détection comprenant un premier transistor de détection (142, 162), et un deuxième transistor de détection (144, 164) connecté en série entre ledit chemin et la ligne de surveillance (VOUT), la borne de grille du premier transistor de détection (142) étant connectée à la ligne de sélection (SEL[j+1]) utilisée pour sélectionner la rangée qui suit la rangée du pixel sélectionné et la borne de grille du deuxième transistor de détection (142) étant connectée à la ligne de sélection (SEL[j-1]) utilisée pour sélectionner la rangée qui précède la rangée du pixel sélectionné, dans lequel l'âge du pixel sélectionné (1064) est extrait durant le deuxième cycle d'extraction en utilisant lesdites lignes de sélection et en surveillant la tension de la ligne de surveillance (VOUT).

4. Système d'affichage, comprenant :
de multiples pixels (1104) agencés dans une matrice de rangées (n) et de colonnes (m), chacun desdits pixels (1104) comportant un dispositif électroluminescent (192, 212), dans lequel le dispositif électroluminescent (192, 212) est une diode électroluminescente organique, un transistor de commande (198, 218) pour commander le dispositif électroluminescent (192, 212), et un transistor de commutation (196, 216) pour sélectionner le pixel (1104) ;
une ligne d'alimentation de puissance (VSS, VDD) pour chacune desdites multiples rangées (n) de pixels (1104) et accouplée audit transistor de commande (198, 218) dans chacun desdits pixels (1104) ;
de multiples lignes de sélection (SEL) pour sélectionner lesdites rangées (n) desdits pixels (1104) dans ladite matrice, chaque rangée étant accouplée à une ligne respective desdites multiples lignes de sélection (SEL) ;
de multiples lignes de données (VDATA) pour fournir des tensions d'étalonnage (VCG) et des données de programmation auxdites colonnes (m) de pixels (1104) dans ladite matrice, chaque colonne étant accouplée à une ligne respective desdites multiples lignes de données (VDATA) ;
un pilote pour alimenter du courant à un pixel sélectionné (1104) d'une i^{ème} rangée afin de produire une tension qui correspond à une caractéristique dudit pixel sélectionné (1104) qui varie avec l'âge de ce pixel (1104) ;
dans lequel le pilote est adapté pour, durant un cycle d'extraction, charger une borne de grille du transistor de commande (198, 218) dans le pixel sélectionné (1104) à une tension d'étalonnage (VCG), et pour maintenir la tension de la ligne de sélection (SEL) du pixel sélectionné (1104) de telle sorte que le transistor de commande (198, 218) dans ledit pixel sélectionné (1104) est polarisé par un courant constant passant par une ligne de surveillance (VOUT) pour le pixel sélectionné (1104) de telle sorte que ledit transistor de commande (198, 218) dans ledit pixel sélectionné (1104) agit comme un amplificateur qui amplifie toute déviation de ladite caractéristique de manière à produire ladite tension qui correspond à la caractéristique dudit pixel sélectionné ; et
un circuit pour détecter ladite tension amplifiée et utiliser la tension amplifiée détectée pour déterminer un ajustement de la tension d'étalonnage (VCG) pour ledit pixel sélectionné (1104) ;
dans lequel chaque pixel comprend un circuit de détection (198, 356, 376) pour surveiller l'âge du pixel, et ledit circuit comprend un réseau de détection pour connecter le circuit de détection (198, 356, 376) à la ligne de surveillance (VOUT), le réseau de détection comprenant un premier transistor de détection (200, 358, 380) qui connecte la ligne de surveillance (VOUT) au circuit de détection (198, 356, 376) et ayant une borne de grille qui est connectée à la ligne de sélection (SEL), dans lequel l'âge du pixel sélectionné est extrait en utilisant ladite ligne de sélection et en surveillant la tension de la ligne de surveillance.

5. Système d'affichage selon l'une des revendications 1 à 4, dans lequel lesdits pixels forment un réseau de pixels rouges, verts, bleus et blancs RGBW, soit Red Green Blue White.

6. Système d'affichage selon la revendication 3, dans lequel la ligne de données (VDATA) pour chaque colonne est utilisée comme ligne de surveillance (VOUT).

7. Système d'affichage selon l'une quelconque des revendications 1 à 6, dans lequel au moins une partie du système est fabriquée en utilisant au moins un matériau sélectionné parmi le groupe constitué par le silicium amorphe, le polysilicium et le silicium nanocristallin ou microcristallin, et en utilisant au moins une technologie sélectionnée parmi le groupe constitué par la technologie des semi-conducteurs organiques, des transistors en couches minces TFT, soit Thin-Film Transistor, la technologie NMOS/PMOS, soit Négative Metal-Oxide-Semiconductor/Positive Metal-Oxide-Semiconductor, la technologie CMOS, soit Complementary Metal-Oxide-Semiconductor, et la technologie MOSFET, soit Metal-Oxide-Semiconductor Field-Effect Transistor.
